# EUROPEAN PATENT APPLICATION

(11) **EP 4 521 467 A1**
(43) Date of publication of application: **12.03.2025**
(21) Application number: 24187387.6
(22) Date of filing: 09.07.2024
(51) Int. Cl.: H01L 27/12

(54) **DISPLAY DEVICE INCLUDING THIN FILM TRANSISTOR AND METHOD OF FABRICATING THE SAME**

(30) Priority: 07.09.2023 KR 20230119075
(71) Applicant: LG Display Co., Ltd., Seoul 07336 (KR)
(72) Inventor: KIM, Jong Woo, 10845 Paju-si, Gyeonggi-do (KR); KIM, Eung-Yong, 10845 Paju-si, Gyeonggi-do (KR)
(74) Representative: Viering, Jentschura & Partner mbB Patent- und Rechtsanwälte

(57) **Abstract**

A display device (110, 210, 310, 410) includes first and second semiconductor layers (124, 126; 224, 226; 324, 326; 424, 426) on a substrate (120, 220, 320, 420), the first and second semiconductor layers (124, 126; 224, 226; 324, 326; 424, 426) including a polycrystalline semiconductor material and an oxide semiconductor material, respectively. The display device (110, 210, 310, 410) includes a first gate insulating layer (128, 228, 328, 428) on the first and second semiconductor layers (124, 126; 224, 226; 324, 326; 424, 426). The display device (110, 210, 310, 410) includes first and second gate electrodes (130, 132; 230, 232; 330, 332; 430, 432) on the first gate insulating layer (128, 228, 328, 428), the first and second gate electrodes (130, 132; 230, 232; 330, 332; 430, 432) corresponding to the first and second semiconductor layers (124, 126; 224, 226; 324, 326; 424, 426), respectively. The display device (110, 210, 310, 410) includes a first interlayer insulating layer (136, 236, 336, 436) on the first gate electrode (130, 230, 330, 430) and the second gate electrode (132, 232, 332, 432). The display device (110, 210, 310, 410) includes first source and drain electrodes and second source and drain electrodes on the first interlayer insulating layer (136, 236, 336, 436), the first source and drain electrodes connected to both end portions, respectively, of the first semiconductor layer (124, 224, 324, 424), the second source and drain electrodes connected to both end portions, respectively, of the second semiconductor layer (126, 226, 326, 426).

## Description

### CROSS-REFERENCE TO RELATED APPLICATIONS

The present application claims the priority benefit of Republic of Korea Patent Application No. 10-2023-0119075 filed in Republic of Korea on September 7, 2023.

### BACKGROUND

### Technical Field

The present disclosure relates to a display device, and more particularly, to an organic light emitting diode display device including a polycrystalline thin film transistor and an oxide transistor and a method of fabricating the display device.

### Description of the Related Art

Recently, with the advent of an information-oriented society and as the interest in information displays for processing and displaying a massive amount of information and the demand for portable information media have increased, a display field has rapidly advanced. Thus, various light and thin flat panel display devices have been developed and highlighted.

Among the various flat panel display devices, an organic light emitting diode (OLED) display device is an emissive type device and does not include a backlight unit used in a non-emissive type device such as a liquid crystal display (LCD) device. As a result, the OLED display device has a light weight and a thin profile and has advantages in a viewing angle, a contrast ratio and a power consumption to be applied to various fields.

A driving unit and a pixel of the OLED display device each includes a thin film transistor. A relatively high mobility is advantageous to the thin film transistor of the driving unit, and a relatively low off current is advantageous to the thin film transistor of the pixel.

### BRIEF SUMMARY

The inventors of the present disclosure have appreciated that when the thin film transistor of the driving unit and the thin film transistor of the pixel are formed of the same semiconductor material through the same process, it is difficult to obtain a relatively high mobility of the thin film transistor of the driving unit and a relatively low off current of the thin film transistor of the pixel. Further, since it is difficult to apply a driving method such as a variable refresh rate (VRR), reduction of a power consumption is limited.

Various embodiments of the present disclosure address one or more problems in the related art, including the above-identified technical problem. In particular, embodiments of the present disclosure are directed to a display device that substantially obviates one or more of problems due to the limitations and disadvantages of the related art.

Various embodiments of the present disclosure provide a display device where a power consumption is reduced by forming a thin film transistor of a polycrystalline semiconductor material and a thin film transistor of an oxide semiconductor material on a same substrate and a method of fabricating the display device.

Various embodiments of the present disclosure provide a display device where a fabricating process is simplified and a fabrication cost is reduced by forming a thin film transistor of a polycrystalline semiconductor material and a thin film transistor of an oxide semiconductor material using a gate insulating layer of a same layer and a gate electrode of a same layer and a method of fabricating the display device.

Additional features and advantages of the disclosure will be set forth in the description which follows, and in part will be apparent to those skilled in the art from the description or may be learned by practice of the disclosure. These and other advantages of the disclosure may be realized and attained by the structure particularly pointed out in, or derivable from, the written description, claims hereof, and the appended drawings.

To achieve these and other advantages and in accordance with the purpose of the present disclosure, as embodied and broadly described herein, a display device according to claim 1 is provided. Further embodiments are described in the dependent claims. A display device according to a first aspect of the present disclosure includes: a substrate having a display area and a non-display area adjacent to (e.g., surrounding) the display area; a first semiconductor layer and a second semiconductor layer on the substrate, the first semiconductor layer disposed in the non-display area and including a polycrystalline semiconductor material, and the second semiconductor layer disposed in the display area and including an oxide semiconductor material; a first gate insulating layer on the first semiconductor layer and the second semiconductor layer; a first gate electrode and a second gate electrode on the first gate insulating layer, the first gate electrode and the second gate electrode corresponding to the first semiconductor layer and the second semiconductor layer, respectively; a first interlayer insulating layer on the first gate electrode and the second gate electrode; and a first source electrode, a first drain electrode, a second source electrode and a second drain electrode on the first interlayer insulating layer, the first source electrode and the first drain electrode connected to both end portions, respectively, of the first semiconductor layer, the second source electrode and the second drain electrode connected to both end portions, respectively, of the second semiconductor layer.

In one or more embodiments, in the display device according to the first aspect of the present disclosure, the first semiconductor layer and the second semiconductor layer have a same layer as each other.

In one or more embodiments, the display device according to the first aspect of the present disclosure further comprises: a first buffer layer between the substrate and the first semiconductor layer and between the substrate and the second semiconductor layer; a second buffer layer, a second interlayer insulating layer, a first planarizing layer and a second planarizing layer sequentially on the first interlayer insulating layer; a storage capacitor between the first gate insulating layer and the second buffer layer; a light emitting diode on the second planarizing layer; and a first encapsulating layer, a second encapsulating layer, and a third encapsulating layer sequentially on the light emitting diode.

In one or more embodiments, the display device according to the first aspect of the present disclosure further comprises: a first gate extending electrode and a second gate extending electrode coupled to the first gate electrode and the second gate electrode, respectively; and a capacitor extending electrode coupled to the storage capacitor, wherein the first gate extending electrode, the first source electrode, the first drain electrode, the second gate extending electrode, the second source electrode and the second drain electrode are disposed on the second interlayer insulating layer and have a same layer and a same material as each other.

In one or more embodiments, the display device according to the first aspect of the present disclosure further comprises a second gate insulating layer on the first semiconductor layer, wherein the second semiconductor layer is disposed on the second gate insulating layer.

In one or more embodiments, the display device according to the first aspect of the present disclosure further comprises a second gate insulating layer on the first semiconductor layer and under the second semiconductor layer.

In one or more embodiments, in the display device according to the first aspect of the present disclosure, the first semiconductor layer and the second gate insulating layer on the first semiconductor layer have a same shape as each other, wherein the second semiconductor layer and the second gate insulating layer under the second semiconductor layer have a same shape as each other.

In one or more embodiments, the display device according to the first aspect of the present disclosure further comprises a first gate extending electrode and a second gate extending electrode on the first interlayer insulating layer, wherein the first gate extending electrode and the second gate extending electrode are coupled to the first gate electrode and the second gate electrode, respectively, and wherein the first gate extending electrode, the first source electrode, the first drain electrode, the second gate extending electrode, the second source electrode and the second drain electrode are disposed on the first interlayer insulating layer and have a same layer and a same material as each other.

In one or more embodiments, the display device according to the first aspect of the present disclosure further comprises: a first buffer layer between the substrate and the first semiconductor layer and between the substrate and the second semiconductor layer; a second buffer layer, a first planarizing layer and a second planarizing layer sequentially on the first interlayer insulating layer; a storage capacitor between the first gate insulating layer and the second buffer layer; a light emitting diode on the second planarizing layer; and a first encapsulating layer, a second encapsulating layer and a third encapsulating layer sequentially on the light emitting diode.

In one or more embodiments, the display device according to the first aspect of the present disclosure further comprises a first source extending electrode, a first drain extending electrode, a second source extending electrode and a second drain extending electrode coupled to the first source electrode, the first drain electrode, the second source electrode and the second drain electrode, respectively, wherein the first source extending electrode, the first drain extending electrode, the second source extending electrode and the second drain extending electrode are disposed on the first planarizing layer and have a same layer and a same material as each other.

In one or more embodiments, in the display device according to the first aspect of the present disclosure, the second source electrode is coupled to the storage capacitor.

In one or more embodiments, the display device according to the first aspect of the present disclosure further comprises: a second gate insulating layer adjacent to the first semiconductor layer and the second semiconductor layer, the second gate insulating layer extending from the first semiconductor layer at the non-display area to the second semiconductor layer at the display area, wherein the first gate insulating layer is on the second gate insulating layer, wherein the display device further comprises a light emitting diode including a first electrode, a second electrode, and an emitting layer between the first and second electrodes, and wherein the first electrode of the light emitting diode is coupled to either the second source electrode or the second drain electrode in the display area.

In one or more embodiments, the display device according to the first aspect of the present disclosure further comprises: a first buffer layer between the substrate and the first and second semiconductor layers, wherein the first buffer layer continuously and contiguously extends from the first semiconductor layer in the non-display area to the second semiconductor layer in the display area, wherein the first buffer layer overlaps both the first semiconductor layer in the non-display area and the second semiconductor layer in the display area from a plan view.

In one or more embodiments, in the display device according to the first aspect of the present disclosure, the first semiconductor layer and the second semiconductor layer directly contact the first buffer layer.

In one or more embodiments, the display device according to the first aspect of the present disclosure further comprises: a capacitor having a first capacitor electrode and a second capacitor electrode on the first capacitor electrode, wherein the first capacitor electrode is between the first gate electrode in the non-display area and the second gate electrode in the display area from a plan view.

In one or more embodiments, in the display device according to the first aspect of the present disclosure, the first gate electrode, the second gate electrode, and the first capacitor electrode are disposed on a same layer as each other and have a same material as each other.

In one or more embodiments, in the display device according to the first aspect of the present disclosure, the second gate insulating layer is disposed on and contacting the first semiconductor layer at the non-display area, and the second semiconductor layer is disposed on and contacting the second gate insulating layer at the display area.

In one or more embodiments, the display device according to the first aspect of the present disclosure further comprises: a first gate extending electrode on and overlapping with the first gate electrode from a plan view, and a second gate extending electrode on and overlapping with the second gate electrode from a plan view.

In one or more embodiments, the display device according to the first aspect of the present disclosure further comprises: a capacitor extending electrode on and overlapping with the second capacitor electrode from a plan view, wherein the first gate extending electrode, the second gate extending electrode, and the capacitor extending electrode are disposed on a same layer as each other and have a same material as each other.

In one or more embodiments, in the display device according to the first aspect of the present disclosure, the first semiconductor layer disposed in the non-display area includes a polycrystalline semiconductor material, and the second semiconductor layer disposed in the display area includes an oxide semiconductor material.

In one or more embodiments, in the display device according to the first aspect of the present disclosure, the second gate insulating layer continuously and contiguously extends from the first semiconductor layer at the non-display area to the second semiconductor layer at the display area, and

In one or more embodiments, the display device according to the first aspect of the present disclosure further comprises: a capacitor having a first capacitor electrode and a second capacitor electrode on the first capacitor electrode; a second drain extending electrode coupled to the second drain electrode; and a second source extending electrode coupled to the second source electrode, wherein the second source extending electrode horizontally extends towards the capacitor and overlaps the second capacitor electrode from a plan view.

In one or more embodiments, in the display device according to the first aspect of the present disclosure, a portion of the second source extending electrode that horizontally extends toward the capacitor vertically extends towards the second capacitor electrode to make an electrical connection.

A display device according to a second aspect of the present disclosure, comprises: a substrate having a display area and a non-display area adjacent to the display area; a first semiconductor layer on the substrate at the non-display area; a second semiconductor layer on the substrate at the display area; a first gate insulating layer adjacent to the first semiconductor layer and the second semiconductor layer, the first gate insulating layer extending from the first semiconductor layer at the non-display area to the second semiconductor layer at the display area; a second gate insulating layer on the first gate insulating layer; a first gate electrode and a second gate electrode on the second gate insulating layer; a first interlayer insulating layer on the first gate electrode and the second gate electrode; and a first source electrode and a first drain electrode on the first interlayer insulating layer at the non-display area; a second source electrode and a second drain electrode on the first interlayer insulating layer at the display area; and a light emitting diode including a first electrode, a second electrode, and an emitting layer between the first and second electrodes, wherein the first electrode of the light emitting diode is coupled to either the second source electrode or the second drain electrode in the display area.

In one or more embodiments, the display device according to the second aspect of the present disclosure further comprises: a first buffer layer between the substrate and the first and second semiconductor layers, wherein the first buffer layer continuously and contiguously extends from the first semiconductor layer in the non-display area to the second semiconductor layer in the display area, wherein the first buffer layer overlaps both the first semiconductor layer in the non-display area and the second semiconductor layer in the display area from a plan view.

In one or more embodiments, in the display device according to the second aspect of the present disclosure, the first semiconductor layer and the second semiconductor layer directly contact the first buffer layer.

In one or more embodiments, the display device according to the second aspect of the present disclosure further comprises: a capacitor having a first capacitor electrode and a second capacitor electrode on the first capacitor electrode, wherein the first capacitor electrode is between the first gate electrode in the non-display area and the second gate electrode in the display area from a plan view.

In one or more embodiments, in the display device according to the second aspect of the present disclosure, the first gate electrode, the second gate electrode, and the first capacitor electrode are disposed on a same layer as each other and have a same material as each other.

In one or more embodiments, in the display device according to the second aspect of the present disclosure, the first gate insulating layer is disposed on and contacting the first semiconductor layer at the non-display area, and wherein the second semiconductor layer is disposed on and contacting the first gate insulating layer at the display area.

In one or more embodiments, the display device according to the second aspect of the present disclosure further comprises: a first gate extending electrode on and overlapping with the first gate electrode from a plan view, and a second gate extending electrode on and overlapping with the second gate electrode from a plan view.

In one or more embodiments, the display device according to the second aspect of the present disclosure further comprises: a capacitor extending electrode on and overlapping with the second capacitor electrode from a plan view, wherein the first gate extending electrode, the second gate extending electrode, and the capacitor extending electrode are disposed on a same layer as each other and have a same material as each other.

In one or more embodiments, in the display device according to the second aspect of the present disclosure, the first semiconductor layer disposed in the non-display area includes a polycrystalline semiconductor material, and the second semiconductor layer disposed in the display area includes an oxide semiconductor material.

In one or more embodiments, in the display device according to the second aspect of the present disclosure, the first gate insulating layer continuously and contiguously extends from the first semiconductor layer at the non-display area to the second semiconductor layer at the display area, and wherein the first gate insulating layer overlaps the first semiconductor layer at the non-display area and the second semiconductor layer at the display area from a plan view.

In one or more embodiments, the display device according to the second aspect of the present disclosure further comprises: a capacitor having a first capacitor electrode and a second capacitor electrode on the first capacitor electrode; a second drain extending electrode coupled to the second drain electrode; and a second source extending electrode coupled to the second source electrode, wherein the second source extending electrode horizontally extends towards the capacitor and overlaps the second capacitor electrode from a plan view.

In one or more embodiments, in the display device according to the second aspect of the present disclosure, a portion of the second source extending electrode that horizontally extends toward the capacitor vertically extends towards the second capacitor electrode to make an electrical connection.

It is to be understood that both the foregoing general description and the following detailed description are explanatory and by way of examples and are intended to provide further explanation of the disclosure as claimed without limiting its scope.

### BRIEF DESCRIPTION OF THE SEVERAL VIEWS OF THE DRAWINGS

The accompanying drawings, which are included to provide a further understanding of the disclosure and are incorporated in and constitute a part of this specification, illustrate embodiments of the disclosure and together with the description serve to explain the principles of the disclosure. In the drawings:
FIG. 1 is a view showing a display device according to a first embodiment of the present disclosure;
FIG. 2 is a cross-sectional view showing a display area and a non-display area of a display device according to a first embodiment of the present disclosure;
FIGs. 3A to 3F are cross-sectional views showing a method of fabricating a display device according to a first embodiment of the present disclosure;
FIG. 4 is a cross-sectional view showing a display area and a non-display area of a display device according to a second embodiment of the present disclosure;
FIGs. 5A to 5F are cross-sectional views showing a method of fabricating a display device according to a second embodiment of the present disclosure;
FIG. 6 is a cross-sectional view showing a display area and a non-display area of a display device according to a third embodiment of the present disclosure;
FIGs. 7A to 7F are cross-sectional views showing a method of fabricating a display device according to a third embodiment of the present disclosure;
FIG. 8 is a cross-sectional view showing a display area and a non-display area of a display device according to a fourth embodiment of the present disclosure; and
FIGs. 9A to 9E are cross-sectional views showing a method of fabricating a display device according to a fourth embodiment of the present disclosure.

### DETAILED DESCRIPTION

Advantages and features of the present disclosure, and implementation methods thereof will be clarified through following exemplary embodiments described with reference to the accompanying drawings. The present disclosure may, however, be embodied in different forms and should not be construed as limited to the exemplary embodiments set forth herein. Rather, these exemplary embodiments are provided so that this disclosure may be sufficiently thorough and complete to assist those skilled in the art to fully understand the scope of the present disclosure. Further, the protected scope of the present disclosure is defined by claims and their equivalents.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

Hereinafter, a display device according to various exemplary embodiments of the present disclosure will be described in detail with reference to the accompanying drawings.

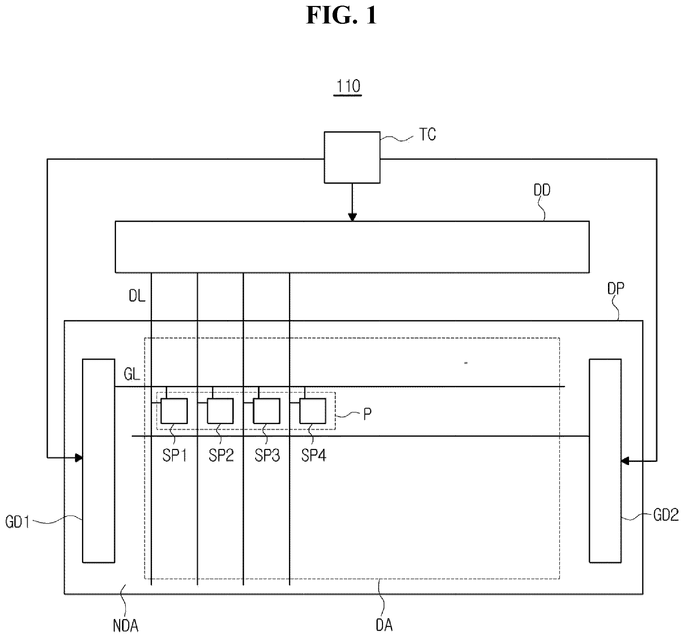

FIG. 1 is a view showing a display device according to a first embodiment of the present disclosure. For example, the display device may be an organic light emitting diode (OLED) display device.

In FIG. 1, a display device 110 according to the first embodiment of the present disclosure includes a timing controlling unit TC, a data driving unit DD, first and second gate driving units GD1 and GD2 and a display panel DP.

The timing controlling unit TC generates an image data, a data control signal and a gate control signal using an image signal and a plurality of timing signals including a data enable signal, a horizontal synchronization signal, a vertical synchronization signal and a clock signal transmitted from an external system such as a graphic card or a television system. The timing controlling unit TC transmits the image data and the data control signal to the data driving unit DD and transmits the gate control signal to the first and second gate driving units GD 1 and GD2.

The data driving unit DD generates a data signal (data voltage) using the data control signal and the image data transmitted from the timing controlling unit TC and supplies the data signal to a data line DL of the display panel DP.

The first and second gate driving units GD 1 and GD2 generate a gate signal (gate voltage) using the gate control signal transmitted from the timing controlling unit TC and supplies the gate signal to a gate line GL of the display panel DP.

For example, the gate signal may include a scan signal, a sensing signal and an emission signal.

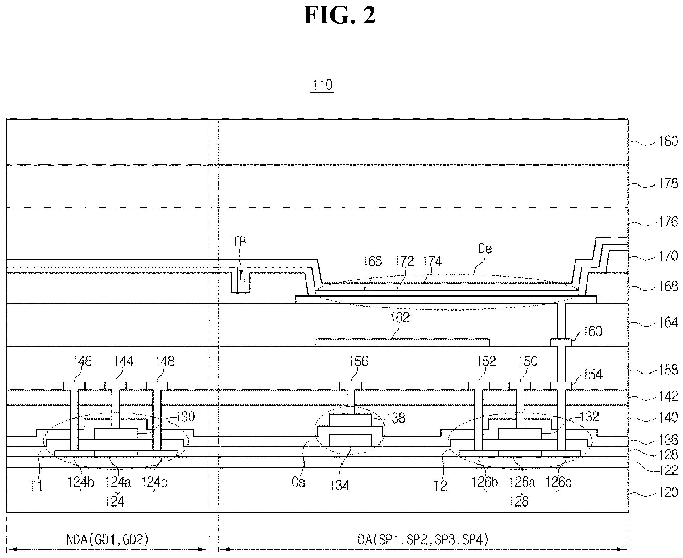

Each of the first and second gate driving units GD 1 and GD2 includes a shift register having a plurality of stages connected to each other as a cascade type, and each stage of the shift register includes a plurality of circuit thin film transistors T 1 (of FIG. 2). At least one of the plurality of circuit thin film transistors T1 may include a semiconductor layer (active layer) of a polycrystalline semiconductor material such as polycrystalline silicon.

The first and second gate driving units GD1 and GD2 may be a gate in panel (GIP) type formed in a non-display area NDA of a substrate of the display panel DP having the gate line GL, the data line DL and a pixel P.

Although the first and second gate driving units GD 1 and GD2 are exemplarily disposed in both side portions of the display panel DP in an embodiment of FIG. 1, one gate driving unit may be disposed in one side portion of the display panel DP in another embodiment.

The display panel DP includes a display area DA at a central portion thereof and a non-display area NDA surrounding the display area DA. The display panel DP displays an image using the gate signal and the data signal. For displaying an image, the display panel DP includes a plurality of pixels P, a plurality of gate lines GL and a plurality of data lines DL in the display area DA.

Each of the plurality of pixels P may include first to fourth subpixels SP1 to SP4. The gate line GL and the data line DL cross each other to define the first to fourth subpixels SP1 to SP4, and each of the first to fourth subpixels SP1 to SP4 is connected to the gate line GL and the data line DL. For example, the first to fourth subpixels SP1 to SP4 may correspond to red, green, blue and white colors, respectively.

Each of the first to fourth subpixels SP1 to SP4 may include a plurality of pixel thin film transistors T2 (of FIG. 2) such as a switching thin film transistor, a driving thin film transistor and a reference thin film transistor, a storage capacitor Cs (of FIG. 2) and a light emitting diode De (of FIG. 2). At least one of the plurality of pixel thin film transistors T2 may include a semiconductor layer (active layer) of an oxide semiconductor material such as indium gallium zinc oxide (IGZO).

A cross-sectional structure of the display device 110 will be described with reference to a drawing.

FIG. 2 is a cross-sectional view showing a display area and a non-display area of a display device according to a first embodiment of the present disclosure.

In FIG. 2, a first thin film transistor T1 as the circuit thin film transistor is disposed in the first and second gate driving units GD 1 and GD2 of the non-display area NDA of the display device 110 according to a first embodiment of the present disclosure, and a second thin film transistor T2 as the pixel thin film transistor, a storage capacitor Cs and a light emitting diode De are disposed in each of the first to fourth subpixels SP1 to SP4 of the display area DA.

A first buffer layer 122 is disposed on an entire substrate 120. A first semiconductor layer 124 is disposed on the first buffer layer 122 in the first and second gate driving units GD1 and GD2 of the non-display area NDA, and a second semiconductor layer 126 is disposed on the first buffer layer 122 in each of the first to fourth subpixels SP1 to SP4 of the display area DA.

For example, the first buffer layer 122 may have a single layer or a multiple layer of an inorganic insulating material such as silicon oxide (SiO2) and silicon nitride (SiNx).

The first semiconductor layer 124 includes a channel region 124a which is not doped with an impurity and source and drain regions 124b and 124c which are doped with an impurity at both sides of the channel region 124a. The second semiconductor layer 126 includes a channel region 126a which is not doped with an impurity and source and drain regions 126b and 126c which are doped with an impurity (or conductorized) at both sides of the channel region 126a.

For example, the first semiconductor layer 124 may include a polycrystalline semiconductor material such as polycrystalline silicon, and the second semiconductor layer 126 may include an oxide semiconductor material such as indium gallium zinc oxide (IGZO), zinc oxide (ZnO), tin oxide (SnO2), copper oxide (Cu2O), nickel oxide (NiO), indium tin zinc oxide (ITZO) and indium aluminum zinc oxide (IAZO).

A first gate insulating layer 128 is disposed on the first semiconductor layer 124 and the second semiconductor layer 126 over the entire substrate 120. A first gate electrode 130 is disposed on the first gate insulating layer 128 corresponding to the first semiconductor layer 124, and a second gate electrode 132 is disposed on the first gate insulating layer 128 corresponding to the second semiconductor layer 126. A first capacitor electrode 134 is disposed on the first gate insulating layer 128 in each of the first to fourth subpixels SP1 to SP4 of the display area DA.

For example, the first gate insulating layer 128 may have a single layer or a multiple layer of an inorganic insulating material such as silicon oxide (SiO2) and silicon nitride (SiNx).

The first gate electrode 130, the second gate electrode 132 and the first capacitor electrode 134 may be disposed on the same layer as each other and have the same material as each other.

For example, the first gate electrode 130, the second gate electrode 132 and the first capacitor electrode 134 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first gate electrode 130, the first gate insulating layer 128 and the first semiconductor layer 124 constitute the first thin film transistor T1, and the second gate electrode 132, the first gate insulating layer 128 and the second semiconductor layer 126 constitute the second thin film transistor T2.

A first interlayer insulating layer 136 is disposed on the first gate electrode 130, the second gate electrode 132 and the first capacitor electrode 134 over the entire substrate 120, and a second capacitor electrode 138 is disposed on the first interlayer insulating layer 136 corresponding to the first capacitor electrode 134.

For example, the first interlayer insulating layer 136 may have a single layer or a multiple layer of an inorganic insulating material such as silicon oxide (SiO2) and silicon nitride (SiNx).

For example, the second capacitor electrode 138 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first capacitor electrode 134, the first interlayer insulating layer 136 and the second capacitor electrode 138 constitute the storage capacitor Cs.

A second buffer layer 140 is disposed on the second capacitor electrode 138 over the entire substrate 120, and a second interlayer insulating layer 142 is disposed on the second buffer layer 140 over the entire substrate 120.

For example, the second buffer layer 140 may have a single layer or a multiple layer of an inorganic insulating material such as silicon oxide (SiO2) and silicon nitride (SiNx), and the second interlayer insulating layer 142 may have a single layer or a multiple layer of an inorganic insulating material such as silicon oxide (SiO2) and silicon nitride (SiNx).

A first gate extending electrode 144, a first source electrode 146 and a first drain electrode 148 are disposed on the second interlayer insulating layer 142 corresponding to the first thin film transistor T1, and a second gate extending electrode 150, a second source electrode 152 and a second drain electrode 154 are disposed on the second interlayer insulating layer 142 corresponding to the second thin film transistor T2. A capacitor extending electrode 156 is disposed on the second interlayer insulating layer 142 corresponding to the storage capacitor Cs, and a first planarizing layer 158 is disposed on the first gate extending electrode 144, the first source electrode 146, the first drain electrode 148, the second gate extending electrode 150, the second source electrode 152, the second drain electrode 154 and the capacitor extending electrode 156 over the entire substrate 120.

The first gate extending electrode 144 is connected to the first gate electrode 130 through a contact hole in the second interlayer insulating layer 142, the second buffer layer 140 and the first interlayer insulating layer 136. The first source electrode 146 is connected to the source region 124b of the first semiconductor layer 124 through a contact hole in the second interlayer insulating layer 142, the second buffer layer 140, the first interlayer insulating layer 136 and the first gate insulating layer 128, and the first drain electrode 148 is connected to the drain region 124c of the first semiconductor layer 124 through a contact hole in the second interlayer insulating layer 142, the second buffer layer 140, the first interlayer insulating layer 136 and the first gate insulating layer 128.

The second gate extending electrode 150 is connected to the second gate electrode 132 through a contact hole in the second interlayer insulating layer 142, the second buffer layer 140 and the first interlayer insulating layer 136. The second source electrode 152 is connected to the source region 126b of the second semiconductor layer 126 through a contact hole in the second interlayer insulating layer 142, the second buffer layer 140, the first interlayer insulating layer 136 and the first gate insulating layer 128, and the second drain electrode 154 is connected to the drain region 126c of the second semiconductor layer 126 through a contact hole in the second interlayer insulating layer 142, the second buffer layer 140, the first interlayer insulating layer 136 and the first gate insulating layer 128.

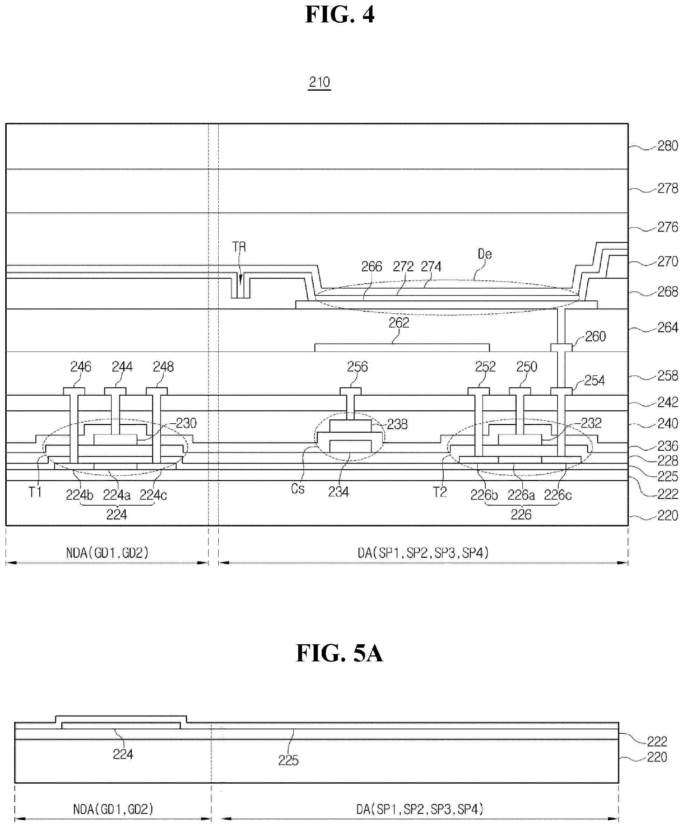

In some embodiments, the first gate extending electrode 144 is on and overlaps with the first gate electrode 130 from a plan view. Similarly, the second gate extending electrode 150 is on and overlaps with the second gate electrode 132 from a plan view. Similar configuration is illustrated in FIGS. 4, 6, and 8. However, similar descriptions will not be repeated to avoid redundancy.

The capacitor extending electrode 156 is connected to the second capacitor electrode 138 through a contact hole in the second interlayer insulating layer 142 and the second buffer layer 140.

The first gate extending electrode 144, the first source electrode 146, the first drain electrode 148, the second gate extending electrode 150, the second source electrode 152, the second drain electrode 154 and the capacitor extending electrode 156 may have the same layer and the same material as each other.

For example, the first gate extending electrode 144, the first source electrode 146, the first drain electrode 148, the second gate extending electrode 150, the second source electrode 152, the second drain electrode 154 and the capacitor extending electrode 156 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the first planarizing layer 158 may have a single layer and a multiple layer of an inorganic insulating material such as photoacryl and benzocyclobutene (BCB).

A first connecting electrode 160 and a second connecting electrode 162 are disposed on the first planarizing layer 158 in each of the first to fourth subpixels SP1 to SP4 of the display area DA, and a second planarizing layer 164 is disposed on the first connecting electrode 160 and the second connecting electrode 162 over the entire substrate 120.

The first connecting electrode 160 is connected to the second drain electrode 154 through a contact hole in the first planarizing layer 158.

Although not shown, the second connecting electrode 162 may be connected to the second source electrode 152 and the capacitor extending electrode 156.

The first connecting electrode 160 and the second connecting electrode 162 may have the same layer and the same material as each other.

For example, the first connecting electrode 160 and the second connecting electrode 162 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the second planarizing layer 164 may have a single layer and a multiple layer of an inorganic insulating material such as photoacryl and benzocyclobutene (BCB).

A first electrode 166 is disposed on the second planarizing layer 164 in each of the first to fourth subpixels SP1 to SP4 of the display area DA, and a bank layer 168 is disposed on the first electrode 166 over the entire substrate 120.

The first electrode 166 is connected to the first connecting electrode 160 through a contact hole in the second planarizing layer 164.

For example, the first electrode 166 may be an anode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The bank layer 168 covers an edge portion of the first electrode 166 and has an opening exposing a central portion of the first electrode 166.

For example, the bank layer 168 may have a single layer and a multiple layer of an inorganic insulating material such as photoacryl and benzocyclobutene (BCB).

A trench TR may be formed in a top surface of the bank layer 168 corresponding to a border portion between adjacent two of the first to fourth subpixels SP1 to SP4, and a spacer 170 may be disposed on the bank layer 168. The plurality of trenches TR may be disposed between the adjacent two of the first to fourth subpixels SP1 to SP4, and a bottom surface of the trench TR may contact the second planarizing layer 164 to expose the second planarizing layer 164.

An emitting layer 172 is disposed on the first electrode 166 over the entire substrate 120, and a second electrode 174 is disposed on the emitting layer 172 over the entire substrate 120.

The emitting layer 172 contacts the first electrode 166 exposed through the opening of the bank layer 168, a sidewall of the opening of the bank layer 168, a top surface of the bank layer 168 and a sidewall and a top surface of the spacer 170. The emitting layer 172 may be divided at the border portion between the adjacent two of the first to fourth subpixels SP1 to SP4 due to the trench TR.

The emitting layer 172 may include a hole relating layer such as a hole injecting layer and a hole transporting layer and an electron relating layer such as an electron transporting layer and an electron injecting layer.

The second electrode 174 may not be divided due to the trench TR and may be connected and extend over the trench TR.

For example, the second electrode 174 may be a cathode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The first electrode 166, the emitting layer 172 and the second electrode 174 constitute the light emitting diode De.

A first encapsulating layer 176, a second encapsulating layer 178 and a third encapsulating layer 180 are sequentially disposed on the second electrode 174 over the entire substrate 120 for preventing a permeation of a moisture.

For example, the first encapsulating layer 176 and the third encapsulating layer 180 may have a single layer or a multiple layer of an inorganic insulating material such as silicon oxide (SiO2) and silicon nitride (SiNx), and the second encapsulating layer 178 may include an organic insulating material such as an acrylic resin, an epoxy resin, a phenolic resin, a polyamide resin and a polyimide resin.

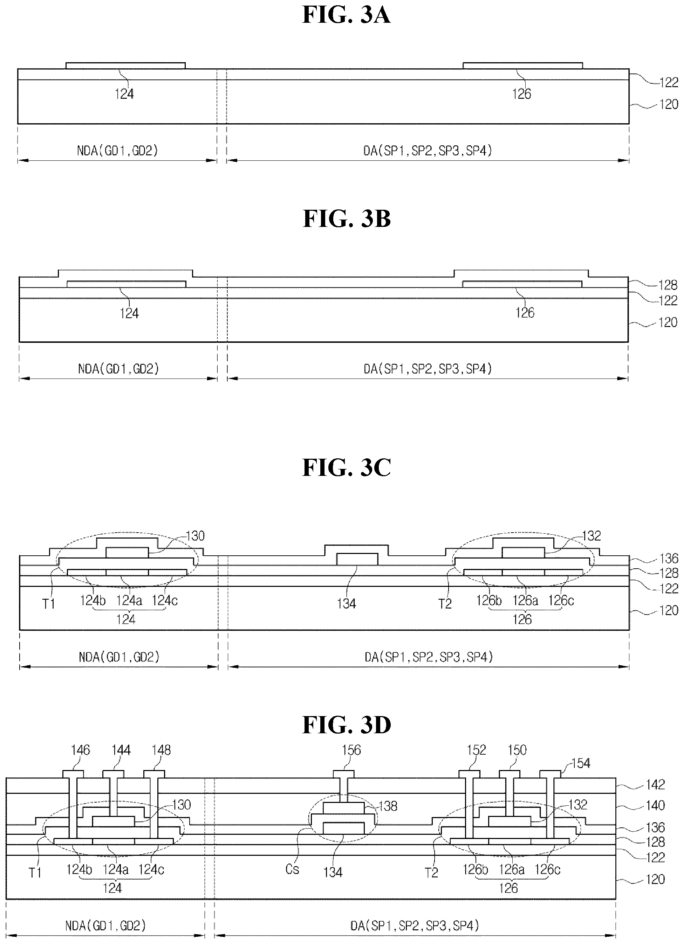

Referring to FIG. 2, the first gate insulating layer 128 is adjacent to the first semiconductor layer 124 and the second semiconductor layer 126. The first gate insulating layer 128 extends from the first semiconductor layer 124 at the non-display area NDA to the second semiconductor layer 126 at the display area DA as shown in FIG. 3B. In particular, the first gate insulating layer 128 continuously and contiguously extends from the first semiconductor layer 124 at the non-display area NDA to the second semiconductor layer 126 at the display area DA as shown in FIG. 3B. Here, the first gate insulating layer 128 overlaps both the first semiconductor layer 124 in the non-display area NDA and the second semiconductor layer 126 in the display area DA from a plan view. This may be beneficial since the transistor in the non-display area NDA (e.g., transistor T1) and the transistor in the display area DA (e.g., transistor T2) can be formed concurrently.

The first buffer layer 122 is between the substrate 120 and the first semiconductor layer 124 and second semiconductor layer 126. The first buffer layer 122 continuously and contiguously extends from the first semiconductor layer 124 in the non-display area NDA to the second semiconductor layer 126 in the display area DA. Here, the first buffer layer 122 overlaps both the first semiconductor layer 124 in the non-display area NDA and the second semiconductor layer 126 in the display area DA from a plan view. In addition, the first semiconductor layer 124 and the second semiconductor layer 126 directly contact the first buffer layer 122.

A fabrication method of the display device 110 will be described with reference to drawings.

FIGs. 3A to 3F are cross-sectional views showing a method of fabricating a display device according to a first embodiment of the present disclosure.

In FIG. 3A, the first buffer layer 122 is disposed on the entire substrate 120.

Next, after a polycrystalline semiconductor material layer (not shown) is formed on the first buffer layer 122, the polycrystalline semiconductor material layer is patterned to form the first semiconductor layer 124 in the first and second gate driving units GD 1 and GD2 of the non-display area NDA.

Next, after an oxide semiconductor material layer (not shown) is formed on the first semiconductor layer 124 and the first buffer layer 122, the oxide semiconductor material layer is patterned to form the second semiconductor layer 126 in each of the first to fourth subpixels SP1 to SP4 of the display area DA.

In FIG. 3B, the first gate insulating layer 128 is formed on the first semiconductor layer 124 and the second semiconductor layer 126 over the entire substrate 120.

In FIG. 3C, after a first metallic material layer (not shown) is formed on the first gate insulating layer 128, the first metallic material layer is patterned to form the first gate electrode 130 corresponding to the first semiconductor layer 124, the second gate electrode 132 corresponding to the second semiconductor layer 126 and the first capacitor electrode 134 in each of the first to fourth subpixels SP1 to SP4 of the display area DA.

Next, the first semiconductor layer 124 and the second semiconductor layer 126 are doped with an impurity of a negative type or a positive type using the second gate electrode 132 as a doping mask to divide the first semiconductor layer 124 into the channel region 124a which is not doped with an impurity and the source and drain regions 124b and 124c which are doped with an impurity and to divide the second semiconductor layer 126 into the channel region 126a which is not doped with an impurity and the source and drain regions 126b and 126c which are doped with an impurity (or conductorized).

The first gate electrode 130, the first gate insulating layer 128 and the first semiconductor layer 124 constitute the first thin film transistor T1, and the second gate electrode 132, the first gate insulating layer 128 and the second semiconductor layer 126 constitute the second thin film transistor T2.

Next, the first interlayer insulating layer 136 is formed on the first gate electrode 130, the second gate electrode 132 and the first capacitor electrode 134 over the entire substrate 120.

In FIG. 3D, after a second metallic material layer (not shown) is formed on the first interlayer insulating layer 136, the second metallic material layer is patterned to form the second capacitor electrode 138 corresponding to the first capacitor electrode 134.

The first capacitor electrode 134, the first interlayer insulating layer 136 and the second capacitor electrode 138 constitute the storage capacitor Cs.

Next, after the second buffer layer 140 is formed on the second capacitor electrode 138 over the entire substrate 120 and the second interlayer insulating layer 142 is formed on the second buffer layer 140 over the entire substrate 120, the second buffer layer 140 and the second interlayer insulating layer 142 are patterned. As a result, the contact hole exposing the first gate electrode 130 is formed in the second interlayer insulating layer 142, the second buffer layer 140 and the first interlayer insulating layer 136, the contact hole exposing the source region 124b of the first semiconductor layer 124 is formed in the second interlayer insulating layer 142, the second buffer layer 140, the first interlayer insulating layer 136 and the first gate insulating layer 128, and the contact hole exposing the drain region 124c of the first semiconductor layer 124 is formed in the second interlayer insulating layer 142, the second buffer layer 140, the first interlayer insulating layer 136 and the first gate insulating layer 128. The contact hole exposing the second gate electrode 132 is formed in the second interlayer insulating layer 142, the second buffer layer 140 and the first interlayer insulating layer 136, the contact hole exposing the source region 126b of the second semiconductor layer 126 is formed in the second interlayer insulating layer 142, the second buffer layer 140, the first interlayer insulating layer 136 and the first gate insulating layer 128, and the contact hole exposing the drain region 126c of the second semiconductor layer 126 is formed in the second interlayer insulating layer 142, the second buffer layer 140, the first interlayer insulating layer 136 and the first gate insulating layer 128. The contact hole exposing the second capacitor electrode 138 is formed in the second interlayer insulating layer 142 and the second buffer layer 140.

Next, after a third metallic material layer (not shown) is formed on the second interlayer insulating layer 142 over the entire substrate 120, the third metallic material layer is patterned to form the first gate extending electrode 144, the first source electrode 146 and the first drain electrode 148 corresponding to the first thin film transistor T1, the second gate extending electrode 150, the second source electrode 152 and the second drain electrode 154 corresponding to the second thin film transistor T2, and the capacitor extending electrode 156 corresponding to the storage capacitor Cs.

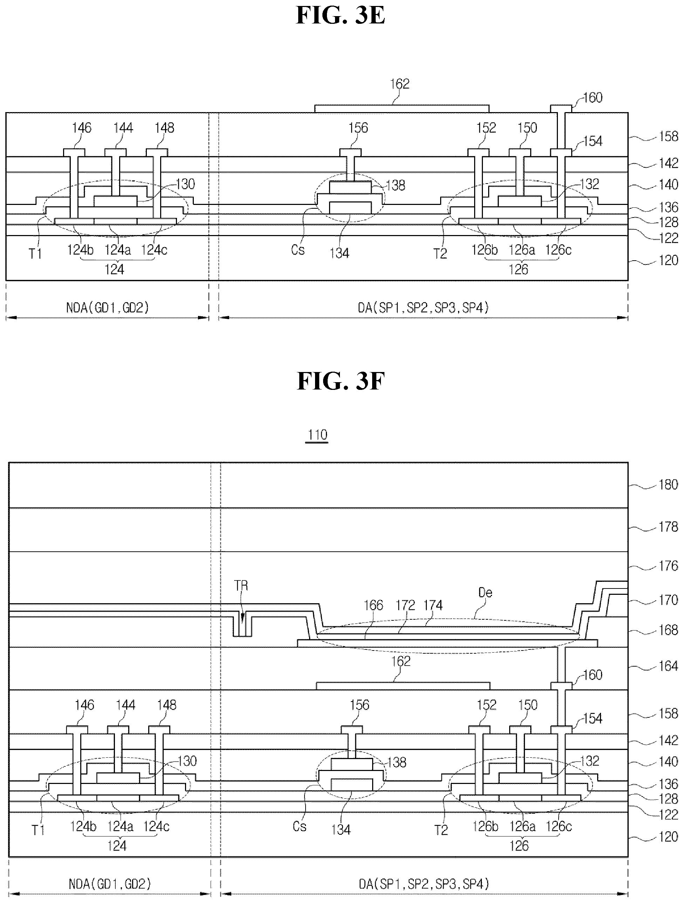

In FIG. 3E, after the first planarizing layer 158 is formed on the first gate extending electrode 144, the first source electrode 146, the first drain electrode 148, the second gate extending electrode 150, the second source electrode 152, the second drain electrode 154 and the capacitor extending electrode 156 over the entire substrate 120, the first planarizing layer 158 is patterned to form the contact hole exposing the second drain electrode 154 in the first planarizing layer 158.

Next, after a fourth metallic material layer (not shown) is formed on the first planarizing layer 158 over the entire substrate 120, the fourth metallic material layer is patterned to form the first connecting electrode 160 and the second connecting electrode 162 in each of the first to fourth subpixels SP1 to SP4 of the display area DA.

In FIG. 3F, after the second planarizing layer 164 is formed on the first connecting electrode 160 and the second connecting electrode 162 over the entire substrate 120, the second planarizing layer 164 is patterned to form the contact hole exposing the first connecting electrode 160 in the second planarizing layer 164.

Next, after a first electrode material layer (not shown) is formed on the second planarizing layer 164 over the entire substrate 120, the first electrode material layer is patterned to form the first electrode 166 in each of the first to fourth subpixels SP1 to SP4 of the display area DA.

Next, the bank layer 168 covering the edge portion of the first electrode 166 and having the opening exposing the central portion of the first electrode 166 is formed on the first electrode 166, and the spacer 170 is disposed on the bank layer 168. The trench TR is formed on the top surface of the bank layer 168 corresponding to the border portion between the adjacent two of the first to fourth subpixels SP1 to SP4.

Next, the emitting layer 172 is formed on the first electrode 166 over the entire substrate 120. The emitting layer 172 may be divided at the border portion between the adjacent two of the first to fourth subpixels SP1 to SP4 due to the trench TR.

Next, the second electrode 174 is disposed on the emitting layer 172 over the entire substrate 120. The second electrode 174 may not be divided due to the trench TR and may be connected and extend over the trench TR.

The first electrode 166, the emitting layer 172 and the second electrode 174 constitute the light emitting diode De.

Next, the first encapsulating layer 176, the second encapsulating layer 178 and the third encapsulating layer 180 are sequentially formed on the second electrode 174 over the entire substrate 120 to complete the display device 110.

Consequently, in the display device 110 according to a first embodiment of the present disclosure, since the first thin film transistor T1 using a polycrystalline semiconductor material as the semiconductor layer (active layer) and the second thin film transistor T2 using an oxide semiconductor material as the semiconductor layer (active layer) are disposed on the single substrate 120, the first thin film transistor T1 of the first and second gate driving units GD1 and GD2 has a relatively high mobility and the second thin film transistor T2 of each of the first to fourth subpixels SP1 to SP4 has a relatively low off current. As a result, a driving method such as a variable refresh rate (VRR) where a static image may be driven with a relatively low refresh rate and a moving image may be driven with a relatively high refresh rate is applied to the display device 110, and a power consumption is reduced.

Further, the first semiconductor layer 124 of a polycrystalline semiconductor material and the second semiconductor layer 126 of an oxide semiconductor material are formed as the same layer, the first gate insulating layer 128 is formed commonly on the first semiconductor layer 124 and the second semiconductor layer 126, and the first gate electrode 130 and the second gate electrode 132 are formed as the same layer of the same material. As a result, a fabrication process is simplified and a fabrication cost is reduced.

In another embodiment, a reliability of a first semiconductor layer is improved by forming a second gate insulating layer between a first semiconductor layer and a second semiconductor layer.

FIG. 4 is a cross-sectional view showing a display area and a non-display area of a display device according to a second embodiment of the present disclosure. Illustration on a part the same as that of the first embodiment may be omitted.

In FIG. 4, a first thin film transistor T1 as a circuit thin film transistor is disposed in first and second gate driving units GD1 and GD2 of a non-display area NDA of a display device 210 according to a second embodiment of the present disclosure, and a second thin film transistor T2 as a pixel thin film transistor, a storage capacitor Cs and a light emitting diode De are disposed in each of first to fourth subpixels SP1 to SP4 of a display area DA.

A first buffer layer 222 is disposed on an entire substrate 220. A first semiconductor layer 224 is disposed on the first buffer layer 222 in the first and second gate driving units GD1 and GD2 of the non-display area NDA.

For example, the first buffer layer 222 may have a single layer or a multiple layer of an inorganic insulating material such as silicon oxide (SiO2) and silicon nitride (SiNx).

The first semiconductor layer 224 includes a channel region 224a which is not doped with an impurity and source and drain regions 224b and 224c which are doped with an impurity at both sides of the channel region 224a.

For example, the first semiconductor layer 224 may include a polycrystalline semiconductor material such as polycrystalline silicon.

A second gate insulating layer 225 is disposed on the first semiconductor layer 224 over the entire substrate 220, and a second semiconductor layer 226 is disposed on the second gate insulating layer 225 in each of the first to fourth subpixels SP1 to SP4 of the display area DA.

For example, the second gate insulating layer 225 may have a single layer or a multiple layer of an inorganic insulating material such as silicon oxide (SiO2) and silicon nitride (SiNx).

The second semiconductor layer 226 includes a channel region 226a which is not doped with an impurity and source and drain regions 226b and 226c which are doped with an impurity (conductorized) at both sides of the channel region 226a.

For example, the second semiconductor layer 226 may include an oxide semiconductor material such as indium gallium zinc oxide (IGZO), zinc oxide (ZnO), tin oxide (SnO2), copper oxide (Cu2O), nickel oxide (NiO), indium tin zinc oxide (ITZO) and indium aluminum zinc oxide (IAZO).

A first gate insulating layer 228 is disposed on the second semiconductor layer 226 over the entire substrate 220. A first gate electrode 230 is disposed on the first gate insulating layer 228 corresponding to the first semiconductor layer 224, and a second gate electrode 232 is disposed on the first gate insulating layer 228 corresponding to the second semiconductor layer 226. A first capacitor electrode 234 is disposed on the first gate insulating layer 228 in each of the first to fourth subpixels SP1 to SP4 of the display area DA.

The second gate insulating layer 225 is disposed on the first semiconductor layer 224, the second semiconductor layer 226 is disposed on the second gate insulating layer 225, and the first gate insulating layer 228 is disposed commonly on the first semiconductor layer 224 and the second semiconductor layer 226. As a result, the second gate insulating layer 225 is formed under a condition suitable for the first semiconductor layer 224 of a polycrystalline semiconductor material (e.g., a condition based on a property change of the first semiconductor layer 224 according to an etching solution, a property change according to a deposition temperature of the first semiconductor layer 224 and the second gate insulating layer 225, a property change according to a surface treatment to the first semiconductor layer 224), and the first gate insulating layer 228 is formed under a condition suitable for the second semiconductor layer 226 of an oxide semiconductor material. Accordingly, a reliability of the first semiconductor layer 224 and the second semiconductor layer 226 is improved.

For example, a thickness of the second gate insulating layer 225 may be smaller than a thickness of the first gate insulating layer 228, and the first gate insulating layer 228 may have a single layer or a multiple layer of an inorganic insulating material such as silicon oxide (SiO2) and silicon nitride (SiNx).

The first gate electrode 230, the second gate electrode 232 and the first capacitor electrode 234 may have the same layer and the same material as each other.

For example, the first gate electrode 230, the second gate electrode 232 and the first capacitor electrode 234 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first gate electrode 230, the second gate insulating layer 225, the first gate insulating layer 228 and the first semiconductor layer 224 constitute the first thin film transistor T1, and the second gate electrode 232, the first gate insulating layer 228 and the second semiconductor layer 226 constitute the second thin film transistor T2.

A first interlayer insulating layer 236 is disposed on the first gate electrode 230, the second gate electrode 232 and the first capacitor electrode 234 over the entire substrate 220, and a second capacitor electrode 238 is disposed on the first interlayer insulating layer 236 corresponding to the first capacitor electrode 234.

For example, the first interlayer insulating layer 236 may have a single layer or a multiple layer of an inorganic insulating material such as silicon oxide (SiO2) and silicon nitride (SiNx).

For example, the second capacitor electrode 238 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first capacitor electrode 234, the first interlayer insulating layer 236 and the second capacitor electrode 238 constitute a storage capacitor Cs.

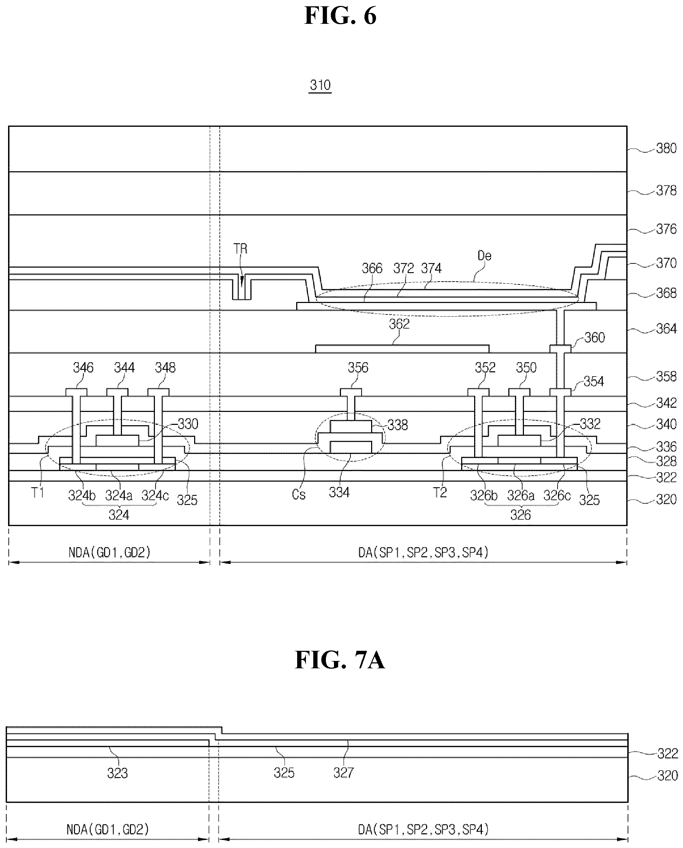

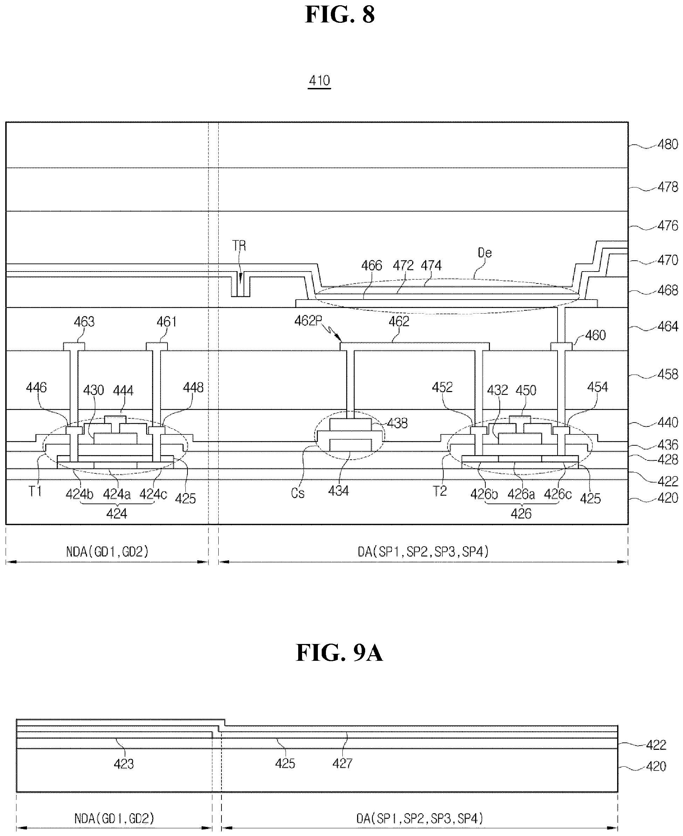

In some embodiments, the first capacitor electrode 234 is between the first gate electrode 230 in the non-display area NDA and the second gate electrode 232 in the display area DA from a plan view. The first capacitor electrode 134 of FIG. 2, the first capacitor electrode 334 of FIG. 6, the first capacitor electrode 434 of FIG. 8 are also between the first gate electrode in the non-display area NDA and the second gate electrode in the display area DA from a plan view. Similar descriptions will not be repeated to avoid redundancy.

A second buffer layer 240 is disposed on the second capacitor electrode 238 over the entire substrate 220, and a second interlayer insulating layer 242 is disposed on the second buffer layer 240 over the entire substrate 220.

For example, the second buffer layer 240 may have a single layer or a multiple layer of an inorganic insulating material such as silicon oxide (SiO2) and silicon nitride (SiNx), and the second interlayer insulating layer 242 may have a single layer or a multiple layer of an inorganic insulating material such as silicon oxide (SiO2) and silicon nitride (SiNx).

A first gate extending electrode 244, a first source electrode 246 and a first drain electrode 248 are disposed on the second interlayer insulating layer 242 corresponding to the first thin film transistor T1, and a second gate extending electrode 250, a second source electrode 252 and a second drain electrode 254 are disposed on the second interlayer insulating layer 242 corresponding to the second thin film transistor T2. A capacitor extending electrode 256 is disposed on the second interlayer insulating layer 242 corresponding to the storage capacitor Cs, and a first planarizing layer 258 is disposed on the first gate extending electrode 244, the first source electrode 246, the first drain electrode 248, the second gate extending electrode 250, the second source electrode 252, the second drain electrode 254 and the capacitor extending electrode 256 over the entire substrate 220.

The first gate extending electrode 244 is connected to the first gate electrode 230 through a contact hole in the second interlayer insulating layer 242, the second buffer layer 240 and the first interlayer insulating layer 236. The first source electrode 246 is connected to the source region 224b of the first semiconductor layer 224 through a contact hole in the second interlayer insulating layer 242, the second buffer layer 240, the first interlayer insulating layer 236, the first gate insulating layer 228 and the second gate insulating layer 225, and the first drain electrode 248 is connected to the drain region 224c of the first semiconductor layer 224 through a contact hole in the second interlayer insulating layer 242, the second buffer layer 240, the first interlayer insulating layer 236, the first gate insulating layer 228 and the second gate insulating layer 225.

The second gate extending electrode 250 is connected to the second gate electrode 232 through a contact hole in the second interlayer insulating layer 242, the second buffer layer 240 and the first interlayer insulating layer 236. The second source electrode 252 is connected to the source region 226b of the second semiconductor layer 226 through a contact hole in the second interlayer insulating layer 242, the second buffer layer 240, the first interlayer insulating layer 236 and the first gate insulating layer 228, and the second drain electrode 254 is connected to the drain region 226c of the second semiconductor layer 226 through a contact hole in the second interlayer insulating layer 242, the second buffer layer 240, the first interlayer insulating layer 236 and the first gate insulating layer 228.

The capacitor extending electrode 256 is connected to the second capacitor electrode 238 through a contact hole in the second interlayer insulating layer 242 and the second buffer layer 240.

The first gate extending electrode 244, the first source electrode 246, the first drain electrode 248 in the non-display area NDA, the second gate extending electrode 250, the second source electrode 252, the second drain electrode 254 in the display area DA and the second capacitor extending electrode 256 may be disposed on the same layer as each other and have the same material as each other.

For example, the first gate extending electrode 244, the first source electrode 246, the first drain electrode 248, the second gate extending electrode 250, the second source electrode 252, the second drain electrode 254 and the capacitor extending electrode 256 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the first planarizing layer 258 may have a single layer and a multiple layer of an inorganic insulating material such as photoacryl and benzocyclobutene (BCB).

A first connecting electrode 260 and a second connecting electrode 262 are disposed on the first planarizing layer 258 in each of the first to fourth subpixels SP1 to SP4 of the display area DA, and a second planarizing layer 264 is disposed on the first connecting electrode 260 and the second connecting electrode 262 over the entire substrate 220.

The first connecting electrode 260 is connected to the second drain electrode 254 through a contact hole in the first planarizing layer 258.

Although not shown, the second connecting electrode 262 may be connected to the second source electrode 252 and the capacitor extending electrode 256.

The first connecting electrode 260 and the second connecting electrode 262 may have the same layer and the same material as each other.

For example, the first connecting electrode 260 and the second connecting electrode 262 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the second planarizing layer 264 may have a single layer and a multiple layer of an inorganic insulating material such as photoacryl and benzocyclobutene (BCB).

A first electrode 266 is disposed on the second planarizing layer 264 in each of the first to fourth subpixels SP1 to SP4 of the display area DA, and a bank layer 268 is disposed on the first electrode 266 over the entire substrate 220.

The first electrode 266 is connected to the first connecting electrode 260 through a contact hole in the second planarizing layer 264.

For example, the first electrode 266 may be an anode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The bank layer 268 covers an edge portion of the first electrode 266 and has an opening exposing a central portion of the first electrode 266.

For example, the bank layer 268 may have a single layer and a multiple layer of an inorganic insulating material such as photoacryl and benzocyclobutene (BCB).

A trench TR may be formed in a top surface of the bank layer 268 corresponding to a border portion between adjacent two of the first to fourth subpixels SP1 to SP4, and a spacer 270 may be disposed on the bank layer 268.

An emitting layer 272 is disposed on the first electrode 266 over the entire substrate 220, and a second electrode 274 is disposed on the emitting layer 272 over the entire substrate 220.

The emitting layer 272 contacts the first electrode 266 exposed through the opening of the bank layer 268, a sidewall of the opening of the bank layer 268, a top surface of the bank layer 268 and a sidewall and a top surface of the spacer 270. The emitting layer 272 may be divided at the border portion between the adjacent two of the first to fourth subpixels SP1 to SP4 due to the trench TR.

The emitting layer 272 may include a hole relating layer such as a hole injecting layer and a hole transporting layer and an electron relating layer such as an electron transporting layer and an electron injecting layer.

The second electrode 274 may not be divided due to the trench TR and may be connected and extend over the trench TR.

For example, the second electrode 274 may be a cathode and may have a single layer or a multiple layer of a transparent conductive material such as one of indium tin oxide (ITO), indium zinc oxide (IZO) and a half transmissive or opaque material such as aluminum (Al), silver (Ag), copper (Cu), lead (Pb), magnesium (Mg), molybdenum (Mo), titanium (Ti) and an alloy thereof.

The first electrode 266, the emitting layer 272 and the second electrode 274 constitute the light emitting diode De.

A first encapsulating layer 276, a second encapsulating layer 278 and a third encapsulating layer 280 are sequentially disposed on the second electrode 274 over the entire substrate 220 for preventing a permeation of a moisture.

For example, the first encapsulating layer 276 and the third encapsulating layer 280 may have a single layer or a multiple layer of an inorganic insulating material such as silicon oxide (SiO2) and silicon nitride (SiNx), and the second encapsulating layer 278 may include an organic insulating material such as an acrylic resin, an epoxy resin, a phenolic resin, a polyamide resin and a polyimide resin.

A fabrication method of the display device 210 will be described with reference to drawings.

FIGs. 5A to 5F are cross-sectional views showing a method of fabricating a display device according to a second embodiment of the present disclosure.

In FIG. 5A, the first buffer layer 222 is disposed on the entire substrate 220.

Next, after a polycrystalline semiconductor material layer (not shown) is formed on the first buffer layer 222, the polycrystalline semiconductor material layer is patterned to form the first semiconductor layer 224 in the first and second gate driving units GD 1 and GD2 of the non-display area NDA.

Next, the second gate insulating layer 225 is formed on the first semiconductor layer 224 and the first buffer layer 222 over the entire substrate 220.

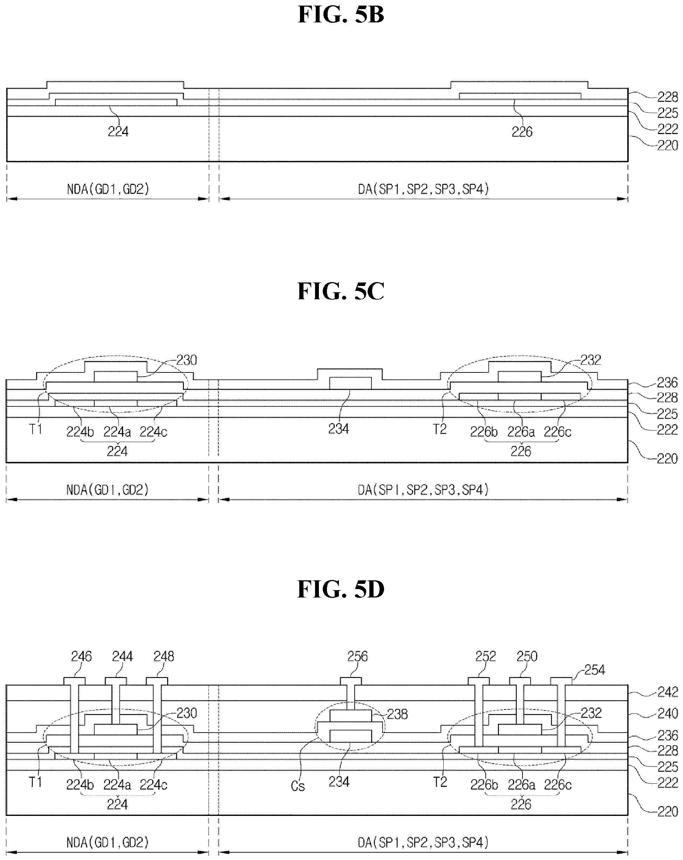

In FIG. 5B, after an oxide semiconductor material layer (not shown) is formed on the second gate insulating layer 225, the oxide semiconductor material layer is patterned to form the second semiconductor layer 226 in each of the first to fourth subpixels SP1 to SP4 of the display area DA.

Next, the first gate insulating layer 228 is formed on the second semiconductor layer 226 over the entire substrate 220.

The second gate insulating layer 225 is disposed on the first semiconductor layer 224, the second semiconductor layer 226 is disposed on the second gate insulating layer 225, and the first gate insulating layer 228 is disposed commonly on the first semiconductor layer 224 and the second semiconductor layer 226. As a result, the second gate insulating layer 225 is formed under a condition suitable for the first semiconductor layer 224 of a polycrystalline semiconductor material (e.g., a condition based on a property change of the first semiconductor layer 224 according to an etching solution, a property change according to a deposition temperature of the first semiconductor layer 224 and the second gate insulating layer 225, a property change according to a surface treatment to the first semiconductor layer 224), and the first gate insulating layer 228 is formed under a condition suitable for the second semiconductor layer 226 of an oxide semiconductor material. Accordingly, a reliability of the first semiconductor layer 224 and the second semiconductor layer 226 is improved.

In some embodiments, as shown in FIG. 5B, the second gate insulating layer 225 is adjacent to the first semiconductor layer 224 and the second semiconductor layer 226. The second gate insulating layer 225 extends from the first semiconductor layer 224 at the non-display area NDA to the second semiconductor layer 226 at the display area DA. In particular, the second gate insulating layer 225 continuously and contiguously extends from the first semiconductor layer 224 at the non-display area NDA to the second semiconductor layer 226 at the display area DA as shown in FIG. 5B. Here, the second gate insulating layer 225 overlaps both the first semiconductor layer 224 in the non-display area NDA and the second semiconductor layer 226 in the display area DA from a plan view. This may be beneficial since the transistor in the non-display area NDA (e.g., transistor T1) and the transistor in the display area DA (e.g., transistor T2) can be formed concurrently. In addition, as shown in FIG. 5B, the second gate insulating layer 225 is disposed on or over the first semiconductor layer 224 in the non-display area NDA. However, the second gate insulating layer 225 is disposed below or beneath the second semiconductor layer 226 in the display area DA. Therefore, in the display area DA, the second semiconductor layer 226 is on and directly contacts the second gate insulating layer 225.

The first buffer layer 222 is between the substrate 220 and the first semiconductor layer 224 and second semiconductor layer 226. The first buffer layer 222 continuously and contiguously extends from the first semiconductor layer 224 in the non-display area NDA to the second semiconductor layer 226 in the display area DA. Here, the first buffer layer 222 overlaps both the first semiconductor layer 224 in the non-display area NDA and the second semiconductor layer 226 in the display area DA from a plan view. In addition, the first semiconductor layer 224 directly contacts the first buffer layer 222. However, the second semiconductor layer 226 and the first buffer layer 222 are spaced apart from each other in the display area DA.

In FIG. 5C, after a first metallic material layer (not shown) is formed on the first gate insulating layer 228, the first metallic material layer is patterned to form the first gate electrode 230 corresponding to the first semiconductor layer 224, the second gate electrode 232 corresponding to the second semiconductor layer 226 and the first capacitor electrode 234 in each of the first to fourth subpixels SP1 to SP4 of the display area DA.

Next, the first semiconductor layer 224 and the second semiconductor layer 226 are doped with an impurity of a negative type or a positive type using the first gate electrode 230 and the second gate electrode 232 as a doping mask to divide the first semiconductor layer 224 into the channel region 224a which is not doped with an impurity and the source and drain regions 224b and 224c which are doped with an impurity and to divide the second semiconductor layer 226 into the channel region 226a which is not doped with an impurity and the source and drain regions 226b and 226c which are doped with an impurity (or conductorized).

The first gate electrode 230, the first gate insulating layer 228, the second gate insulating layer 225 and the first semiconductor layer 224 constitute the first thin film transistor T1, and the second gate electrode 232, the first gate insulating layer 228 and the second semiconductor layer 226 constitute the second thin film transistor T2.

Next, the first interlayer insulating layer 236 is formed on the first gate electrode 230, the second gate electrode 232 and the first capacitor electrode 234 over the entire substrate 220.

In FIG. 5D, after a second metallic material layer (not shown) is formed on the first interlayer insulating layer 236, the second metallic material layer is patterned to form the second capacitor electrode 238 corresponding to the first capacitor electrode 234.

The first capacitor electrode 234, the first interlayer insulating layer 236 and the second capacitor electrode 238 constitute the storage capacitor Cs.

Next, after the second buffer layer 240 is formed on the second capacitor electrode 238 over the entire substrate 220 and the second interlayer insulating layer 242 is formed on the second buffer layer 240 over the entire substrate 220, the second buffer layer 240 and the second interlayer insulating layer 242 are patterned. As a result, the contact hole exposing the first gate electrode 230 is formed in the second interlayer insulating layer 242, the second buffer layer 240 and the first interlayer insulating layer 236, the contact hole exposing the source region 224b of the first semiconductor layer 224 is formed in the second interlayer insulating layer 242, the second buffer layer 240, the first interlayer insulating layer 236, the first gate insulating layer 228 and the second gate insulating layer 225, and the contact hole exposing the drain region 224c of the first semiconductor layer 224 is formed in the second interlayer insulating layer 242, the second buffer layer 240, the first interlayer insulating layer 236, the first gate insulating layer 228 and the second gate insulating layer 225. The contact hole exposing the second gate electrode 232 is formed in the second interlayer insulating layer 242, the second buffer layer 240 and the first interlayer insulating layer 236, the contact hole exposing the source region 226b of the second semiconductor layer 226 is formed in the second interlayer insulating layer 242, the second buffer layer 240, the first interlayer insulating layer 236, the first gate insulating layer 228 and the second gate insulating layer 225, and the contact hole exposing the drain region 226c of the second semiconductor layer 226 is formed in the second interlayer insulating layer 242, the second buffer layer 240, the first interlayer insulating layer 236, the first gate insulating layer 228 and the second gate insulating layer 225. The contact hole exposing the second capacitor electrode 238 is formed in the second interlayer insulating layer 242 and the second buffer layer 240.

Next, after a third metallic material layer (not shown) is formed on the second interlayer insulating layer 242 over the entire substrate 220, the third metallic material layer is patterned to form the first gate extending electrode 244, the first source electrode 246 and the first drain electrode 248 corresponding to the first thin film transistor T1, the second gate extending electrode 250, the second source electrode 252 and the second drain electrode 254 corresponding to the second thin film transistor T2, and the capacitor extending electrode 256 corresponding to the storage capacitor Cs.

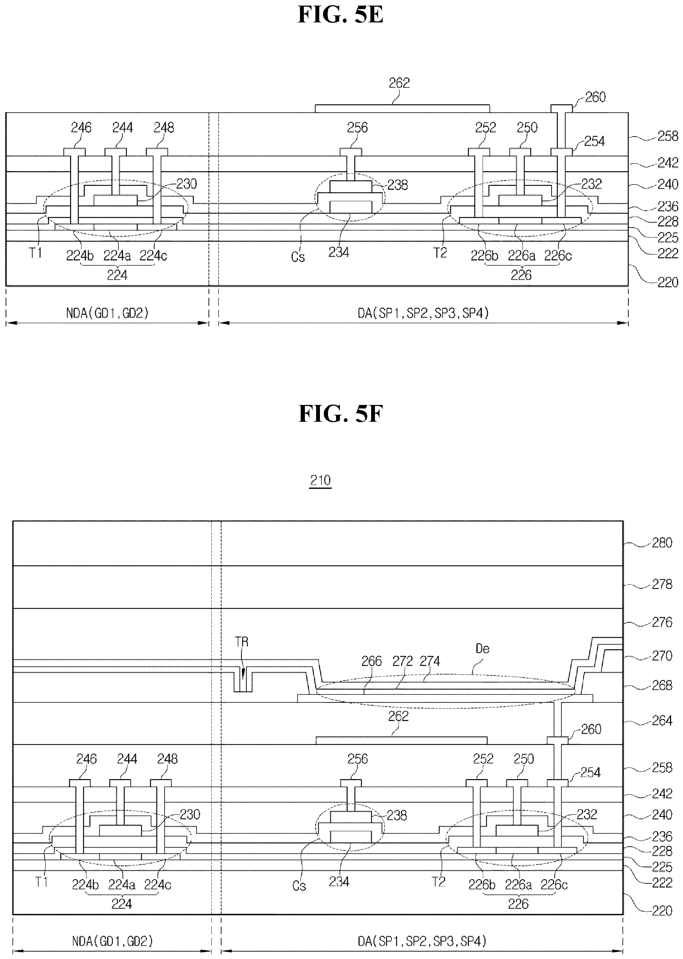

In FIG. 5E, after the first planarizing layer 258 is formed on the first gate extending electrode 244, the first source electrode 246, the first drain electrode 248, the second gate extending electrode 250, the second source electrode 252, the second drain electrode 254 and the capacitor extending electrode 256 over the entire substrate 220, the first planarizing layer 258 is patterned to form the contact hole exposing the second drain electrode 254 in the first planarizing layer 258.

Next, after a fourth metallic material layer (not shown) is formed on the first planarizing layer 258 over the entire substrate 220, the fourth metallic material layer is patterned to form the first connecting electrode 260 and the second connecting electrode 262 in each of the first to fourth subpixels SP1 to SP4 of the display area DA.

In FIG. 5F, after the second planarizing layer 264 is formed on the first connecting electrode 260 and the second connecting electrode 262 over the entire substrate 220, the second planarizing layer 264 is patterned to form the contact hole exposing the first connecting electrode 260 in the second planarizing layer 264.

Next, after a first electrode material layer (not shown) is formed on the second planarizing layer 264 over the entire substrate 220, the first electrode material layer is patterned to form the first electrode 266 in each of the first to fourth subpixels SP1 to SP4 of the display area DA.

Next, the bank layer 268 covering the edge portion of the first electrode 266 and having the opening exposing the central portion of the first electrode 266 is formed on the first electrode 266, and the spacer 270 is disposed on the bank layer 268. The trench TR is formed on the top surface of the bank layer 268 corresponding to the border portion between the adjacent two of the first to fourth subpixels SP1 to SP4.

Next, the emitting layer 272 is formed on the first electrode 266 over the entire substrate 220. The emitting layer 272 may be divided at the border portion between the adjacent two of the first to fourth subpixels SP1 to SP4 due to the trench TR.

Next, the second electrode 274 is disposed on the emitting layer 272 over the entire substrate 220. The second electrode 274 may not be divided due to the trench TR and may be connected and extend over the trench TR.

The first electrode 266, the emitting layer 272 and the second electrode 274 constitute the light emitting diode De.

Next, the first encapsulating layer 276, the second encapsulating layer 278 and the third encapsulating layer 280 are sequentially formed on the second electrode 274 over the entire substrate 220 to complete the display device 210.

Consequently, in the display device 210 according to a second embodiment of the present disclosure, since the first thin film transistor T1 using a polycrystalline semiconductor material as the semiconductor layer (active layer) and the second thin film transistor T2 using an oxide semiconductor material as the semiconductor layer (active layer) are disposed on the single substrate 220, the first thin film transistor T1 of the first and second gate driving units GD1 and GD2 has a relatively high mobility and the second thin film transistor T2 of each of the first to fourth subpixels SP1 to SP4 has a relatively low off current. As a result, a driving method such as a variable refresh rate (VRR) where a static image may be driven with a relatively low refresh rate and a moving image may be driven with a relatively high refresh rate is applied to the display device 210, and a power consumption is reduced.

Further, the first gate insulating layer 228 is formed commonly on the first semiconductor layer 224 of a polycrystalline semiconductor material and the second semiconductor layer 226 of an oxide semiconductor material, and the first gate electrode 230 and the second gate electrode 232 are formed as the same layer of the same material. As a result, a fabrication process is simplified and a fabrication cost is reduced.

In addition, the second gate insulating layer 225 is disposed on the first semiconductor layer 224, the second semiconductor layer 226 is disposed on the second gate insulating layer 225, and the first gate insulating layer 228 is disposed commonly on the first semiconductor layer 224 and the second semiconductor layer 226. As a result, a reliability of the first semiconductor layer 224 and the second semiconductor layer 226 is improved.

In another embodiment, a fabrication process is simplified by forming a first semiconductor layer and a second semiconductor layer using a single photo mask.

FIG. 6 is a cross-sectional view showing a display area and a non-display area of a display device 310 according to a third embodiment of the present disclosure. Illustration on a part the same as that of the first and second embodiments may be omitted.

In FIG. 6, a first thin film transistor T1 as a circuit thin film transistor is disposed in first and second gate driving units GD1 and GD2 of a non-display area NDA of a display device 210 according to a third embodiment of the present disclosure, and a second thin film transistor T2 as a pixel thin film transistor, a storage capacitor Cs and a light emitting diode De are disposed in each of first to fourth subpixels SP1 to SP4 of a display area DA.

A first buffer layer 322 is disposed on an entire substrate 320. A first semiconductor layer 324 is disposed on the first buffer layer 322 in the first and second gate driving units GD1 and GD2 of the non-display area NDA.

For example, the first buffer layer 322 may have a single layer or a multiple layer of an inorganic insulating material such as silicon oxide (SiO2) and silicon nitride (SiNx).

The first semiconductor layer 324 includes a channel region 324a which is not doped with an impurity and source and drain regions 324b and 324c which are doped with an impurity at both sides of the channel region 324a.

For example, the first semiconductor layer 324 may include a polycrystalline semiconductor material such as polycrystalline silicon.

A second gate insulating layer 325 is disposed on the first semiconductor layer 324 and on the first buffer layer 322 in each of the first to fourth subpixels SP1 to SP4 of the display area DA, and a second semiconductor layer 326 is disposed on the second gate insulating layer 325 in each of the first to fourth subpixels SP1 to SP4 of the display area DA.

The first semiconductor layer 324 and the second gate insulating layer 325 on the first semiconductor layer 324 may have the same shape as each other in a plan view, and the second semiconductor layer 326 and the second gate insulating layer 325 under the second semiconductor layer 326 may have the same shape as each other in a plan view.

For example, the second gate insulating layer 325 may have a single layer or a multiple layer of an inorganic insulating material such as silicon oxide (SiO2) and silicon nitride (SiNx).

The second semiconductor layer 326 includes a channel region 326a which is not doped with an impurity and source and drain regions 326b and 326c which are doped with an impurity (conductorized) at both sides of the channel region 326a.

For example, the second semiconductor layer 326 may include an oxide semiconductor material such as indium gallium zinc oxide (IGZO), zinc oxide (ZnO), tin oxide (SnO2), copper oxide (Cu2O), nickel oxide (NiO), indium tin zinc oxide (ITZO) and indium aluminum zinc oxide (IAZO).

A first gate insulating layer 328 is disposed on the second gate insulating layer 325 and the second semiconductor layer 326 over the entire substrate 320. A first gate electrode 330 is disposed on the first gate insulating layer 328 corresponding to the first semiconductor layer 324, and a second gate electrode 332 is disposed on the first gate insulating layer 328 corresponding to the second semiconductor layer 326. A first capacitor electrode 334 is disposed on the first gate insulating layer 328 in each of the first to fourth subpixels SP1 to SP4 of the display area DA.

The second gate insulating layer 325 is disposed on the first semiconductor layer 324, the second semiconductor layer 326 is disposed on the second gate insulating layer 325, and the first gate insulating layer 328 is disposed commonly on the first semiconductor layer 324 and the second semiconductor layer 326. As a result, the second gate insulating layer 325 is formed under a condition suitable for the first semiconductor layer 324 of a polycrystalline semiconductor material (e.g., a condition based on a property change of the first semiconductor layer 324 according to an etching solution, a property change according to a deposition temperature of the first semiconductor layer 324 and the second gate insulating layer 325, a property change according to a surface treatment to the first semiconductor layer 324), and the first gate insulating layer 328 is formed under a condition suitable for the second semiconductor layer 326 of an oxide semiconductor material. Accordingly, a reliability of the first semiconductor layer 324 and the second semiconductor layer 326 is improved.

For example, a thickness of the second gate insulating layer 325 may be smaller than a thickness of the first gate insulating layer 328, and the first gate insulating layer 328 may have a single layer or a multiple layer of an inorganic insulating material such as silicon oxide (SiO2) and silicon nitride (SiNx).

The first gate electrode 330, the second gate electrode 332 and the first capacitor electrode 334 may have the same layer and the same material as each other.

For example, the first gate electrode 330, the second gate electrode 332 and the first capacitor electrode 334 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first gate electrode 330, the second gate insulating layer 325, the first gate insulating layer 328 and the first semiconductor layer 324 constitute the first thin film transistor T1, and the second gate electrode 332, the first gate insulating layer 328 and the second semiconductor layer 326 constitute the second thin film transistor T2.

A first interlayer insulating layer 336 is disposed on the first gate electrode 330, the second gate electrode 332 and the first capacitor electrode 334 over the entire substrate 320, and a second capacitor electrode 338 is disposed on the first interlayer insulating layer 336 corresponding to the first capacitor electrode 334.

For example, the first interlayer insulating layer 336 may have a single layer or a multiple layer of an inorganic insulating material such as silicon oxide (SiO2) and silicon nitride (SiNx).

For example, the second capacitor electrode 338 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first capacitor electrode 334, the first interlayer insulating layer 336 and the second capacitor electrode 338 constitute a storage capacitor Cs.

A second buffer layer 340 is disposed on the second capacitor electrode 338 over the entire substrate 320, and a second interlayer insulating layer 342 is disposed on the second buffer layer 340 over the entire substrate 320.

For example, the second buffer layer 340 may have a single layer or a multiple layer of an inorganic insulating material such as silicon oxide (SiO2) and silicon nitride (SiNx), and the second interlayer insulating layer 342 may have a single layer or a multiple layer of an inorganic insulating material such as silicon oxide (SiO2) and silicon nitride (SiNx).

A first gate extending electrode 344, a first source electrode 346 and a first drain electrode 348 are disposed on the second interlayer insulating layer 342 corresponding to the first thin film transistor T1, and a second gate extending electrode 350, a second source electrode 352 and a second drain electrode 354 are disposed on the second interlayer insulating layer 342 corresponding to the second thin film transistor T2. A capacitor extending electrode 356 is disposed on the second interlayer insulating layer 342 corresponding to the storage capacitor Cs, and a first planarizing layer 358 is disposed on the first gate extending electrode 344, the first source electrode 346, the first drain electrode 348, the second gate extending electrode 350, the second source electrode 352, the second drain electrode 354 and the capacitor extending electrode 356 over the entire substrate 320.

The first gate extending electrode 344 is connected to the first gate electrode 330 through a contact hole in the second interlayer insulating layer 342, the second buffer layer 340 and the first interlayer insulating layer 336. The first source electrode 346 is connected to the source region 324b of the first semiconductor layer 324 through a contact hole in the second interlayer insulating layer 342, the second buffer layer 340, the first interlayer insulating layer 336, the first gate insulating layer 328 and the second gate insulating layer 325, and the first drain electrode 348 is connected to the drain region 324c of the first semiconductor layer 324 through a contact hole in the second interlayer insulating layer 342, the second buffer layer 340, the first interlayer insulating layer 336, the first gate insulating layer 328 and the second gate insulating layer 325.

The second gate extending electrode 350 is connected to the second gate electrode 332 through a contact hole in the second interlayer insulating layer 342, the second buffer layer 340 and the first interlayer insulating layer 336. The second source electrode 352 is connected to the source region 326b of the second semiconductor layer 326 through a contact hole in the second interlayer insulating layer 342, the second buffer layer 340, the first interlayer insulating layer 336, the first gate insulating layer 328 and the second gate insulating layer 325, and the second drain electrode 354 is connected to the drain region 326c of the second semiconductor layer 326 through a contact hole in the second interlayer insulating layer 342, the second buffer layer 340, the first interlayer insulating layer 336, the first gate insulating layer 328 and the second gate insulating layer 325.

The capacitor extending electrode 356 is connected to the second capacitor electrode 338 through a contact hole in the second interlayer insulating layer 342 and the second buffer layer 340.

The first gate extending electrode 344, the first source electrode 346, the first drain electrode 348, the second gate extending electrode 350, the second source electrode 352, the second drain electrode 354 and the second capacitor extending electrode 356 may have the same layer and the same material as each other.

For example, the first gate extending electrode 344, the first source electrode 346, the first drain electrode 348, the second gate extending electrode 350, the second source electrode 352, the second drain electrode 354 and the capacitor extending electrode 356 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the first planarizing layer 358 may have a single layer and a multiple layer of an inorganic insulating material such as photoacryl and benzocyclobutene (BCB).

A first connecting electrode 360 and a second connecting electrode 362 are disposed on the first planarizing layer 358 in each of the first to fourth subpixels SP1 to SP4 of the display area DA, and a second planarizing layer 364 is disposed on the first connecting electrode 360 and the second connecting electrode 362 over the entire substrate 320.

The first connecting electrode 360 is connected to the second drain electrode 354 through a contact hole in the first planarizing layer 358.

Although not shown, the second connecting electrode 362 may be connected to the second source electrode 352 and the capacitor extending electrode 356.

The first connecting electrode 360 and the second connecting electrode 362 may have the same layer and the same material as each other.

For example, the first connecting electrode 360 and the second connecting electrode 362 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the second planarizing layer 364 may have a single layer and a multiple layer of an inorganic insulating material such as photoacryl and benzocyclobutene (BCB).

A first electrode 366 is disposed on the second planarizing layer 364 in each of the first to fourth subpixels SP1 to SP4 of the display area DA, and a bank layer 368 is disposed on the first electrode 366 over the entire substrate 320.

The first electrode 366 is connected to the first connecting electrode 360 through a contact hole in the second planarizing layer 364.

For example, the first electrode 366 may be an anode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The bank layer 368 covers an edge portion of the first electrode 366 and has an opening exposing a central portion of the first electrode 366.

For example, the bank layer 368 may have a single layer and a multiple layer of an inorganic insulating material such as photoacryl and benzocyclobutene (BCB).

A trench TR may be formed in a top surface of the bank layer 368 corresponding to a border portion between adjacent two of the first to fourth subpixels SP1 to SP4, and a spacer 370 may be disposed on the bank layer 368.

An emitting layer 372 is disposed on the first electrode 366 over the entire substrate 320, and a second electrode 374 is disposed on the emitting layer 372 over the entire substrate 320.

The emitting layer 372 contacts the first electrode 366 exposed through the opening of the bank layer 368, a sidewall of the opening of the bank layer 368, a top surface of the bank layer 368 and a sidewall and a top surface of the spacer 370. The emitting layer 372 may be divided at the border portion between the adjacent two of the first to fourth subpixels SP1 to SP4 due to the trench TR.

The emitting layer 372 may include a hole relating layer such as a hole injecting layer and a hole transporting layer and an electron relating layer such as an electron transporting layer and an electron injecting layer.

The second electrode 374 may not be divided due to the trench TR and may be connected and extend over the trench TR.

For example, the second electrode 374 may be a cathode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The first electrode 366, the emitting layer 372 and the second electrode 374 constitute the light emitting diode De.

A first encapsulating layer 376, a second encapsulating layer 378 and a third encapsulating layer 380 are sequentially disposed on the second electrode 374 over the entire substrate 320 for preventing a permeation of a moisture.

For example, the first encapsulating layer 376 and the third encapsulating layer 380 may have a single layer or a multiple layer of an inorganic insulating material such as silicon oxide (SiO2) and silicon nitride (SiNx), and the second encapsulating layer 378 may include an organic insulating material such as an acrylic resin, an epoxy resin, a phenolic resin, a polyamide resin and a polyimide resin.

A fabrication method of the display device 310 will be described with reference to drawings.

FIGs. 7A to 7F are cross-sectional views showing a method of fabricating a display device according to a third embodiment of the present disclosure.

In FIG. 7A, the first buffer layer 322 is disposed on the entire substrate 320.

Next, after an amorphous semiconductor material layer (not shown) is formed on the first buffer layer 322, the amorphous semiconductor material layer in the first and second gate driving units GD1 and GD2 of the non-display area NDA is selectively crystallized and the amorphous semiconductor material layer which is not crystallized is selectively removed to form a polycrystalline semiconductor pattern 323 in the first and second gate driving units GD1 and GD2 of the non-display area NDA.

Next, the second gate insulating layer 325 is formed on the polycrystalline semiconductor pattern 323 and the first buffer layer 322 over the entire substrate 320, and an oxide semiconductor material layer 327 is formed on the second gate insulating layer 325 over the entire substrate 320.

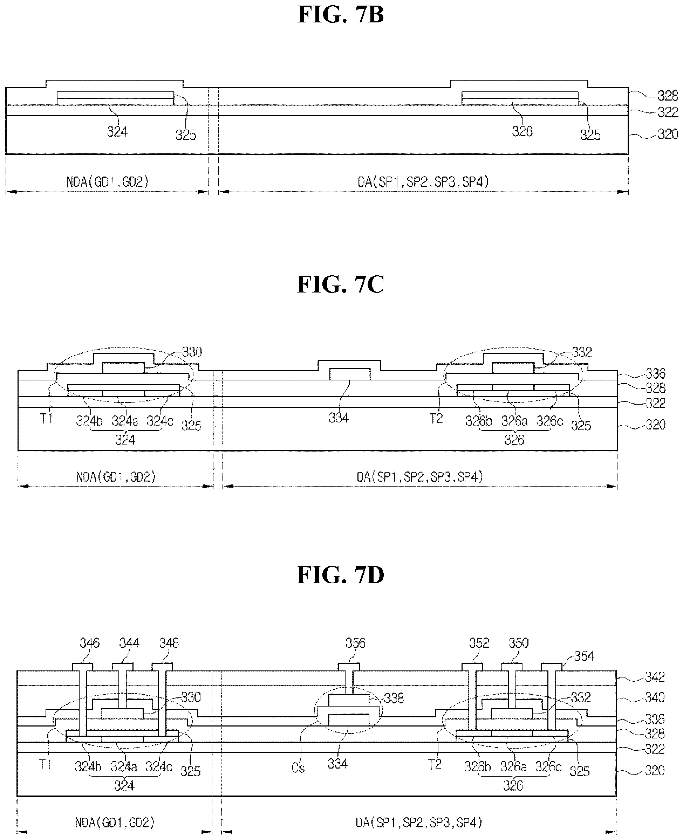

In FIG. 7B, after the oxide semiconductor material layer 327, the first gate insulating layer 325 and the polycrystalline semiconductor pattern 323 of the non-display area NDA and the oxide semiconductor material layer 327 and the first gate insulating layer 325 of the display area DA are etched using a half transmissive mask, a photoresist pattern is partially removed through an ashing to expose the oxide semiconductor material layer 327 of the non-display area NDA. Next, the exposed oxide semiconductor material layer 327 of the non-display area NDA is removed to form the first semiconductor layer 324 and the second gate insulating layer 325 on the first buffer layer 322 in the first and second gate driving units GD1 and GD2 of the non-display area NDA and to form the second gate insulating layer 325 and the second semiconductor layer 326 on the first buffer layer 322 in each of the first to fourth subpixels SP1 to SP4 of the display area DA.

Since the first semiconductor layer 324, the second gate insulating layer 325 and the second semiconductor layer 326 are patterned using a single photo mask, a fabrication process is simplified and a fabrication cost is reduced.

Next, the first gate insulating layer 328 is formed on the second gate insulating layer 325 and the second semiconductor layer 326 over the entire substrate 320.

In FIG. 7C, after a first metallic material layer (not shown) is formed on the first gate insulating layer 328, the first metallic material layer is patterned to form the first gate electrode 330 corresponding to the first semiconductor layer 324, the second gate electrode 332 corresponding to the second semiconductor layer 326 and the first capacitor electrode 334 in each of the first to fourth subpixels SP1 to SP4 of the display area DA.

Next, the first semiconductor layer 324 and the second semiconductor layer 326 are doped with an impurity of a negative type or a positive type using the first gate electrode 330 and the second gate electrode 332 as a doping mask to divide the first semiconductor layer 324 into the channel region 324a which is not doped with an impurity and the source and drain regions 324b and 324c which are doped with an impurity and to divide the second semiconductor layer 326 into the channel region 326a which is not doped with an impurity and the source and drain regions 326b and 326c which are doped with an impurity (or conductorized).

The first gate electrode 330, the first gate insulating layer 328, the second gate insulating layer 325 and the first semiconductor layer 324 constitute the first thin film transistor T1, and the second gate electrode 332, the first gate insulating layer 328 and the second semiconductor layer 326 constitute the second thin film transistor T2.

Next, the first interlayer insulating layer 336 is formed on the first gate electrode 330, the second gate electrode 332 and the first capacitor electrode 334 over the entire substrate 320.

In FIG. 7D, after a second metallic material layer (not shown) is formed on the first interlayer insulating layer 336, the second metallic material layer is patterned to form the second capacitor electrode 338 corresponding to the first capacitor electrode 334.

The first capacitor electrode 334, the first interlayer insulating layer 336 and the second capacitor electrode 338 constitute the storage capacitor Cs.

Next, after the second buffer layer 340 is formed on the second capacitor electrode 338 over the entire substrate 320 and the second interlayer insulating layer 342 is formed on the second buffer layer 340 over the entire substrate 320, the second buffer layer 340 and the second interlayer insulating layer 342 are patterned. As a result, the contact hole exposing the first gate electrode 330 is formed in the second interlayer insulating layer 342, the second buffer layer 340 and the first interlayer insulating layer 336, the contact hole exposing the source region 324b of the first semiconductor layer 324 is formed in the second interlayer insulating layer 342, the second buffer layer 340, the first interlayer insulating layer 336, the first gate insulating layer 328 and the second gate insulating layer 325, and the contact hole exposing the drain region 324c of the first semiconductor layer 324 is formed in the second interlayer insulating layer 342, the second buffer layer 340, the first interlayer insulating layer 336, the first gate insulating layer 328 and the second gate insulating layer 325. The contact hole exposing the second gate electrode 332 is formed in the second interlayer insulating layer 342, the second buffer layer 340 and the first interlayer insulating layer 336, the contact hole exposing the source region 326b of the second semiconductor layer 326 is formed in the second interlayer insulating layer 342, the second buffer layer 340, the first interlayer insulating layer 336 and the first gate insulating layer 328, and the contact hole exposing the drain region 326c of the second semiconductor layer 326 is formed in the second interlayer insulating layer 342, the second buffer layer 340, the first interlayer insulating layer 336 and the first gate insulating layer 328. The contact hole exposing the second capacitor electrode 338 is formed in the second interlayer insulating layer 342 and the second buffer layer 340.

Next, after a third metallic material layer (not shown) is formed on the second interlayer insulating layer 342 over the entire substrate 320, the third metallic material layer is patterned to form the first gate extending electrode 344, the first source electrode 346 and the first drain electrode 348 corresponding to the first thin film transistor T1, the second gate extending electrode 350, the second source electrode 352 and the second drain electrode 354 corresponding to the second thin film transistor T2, and the capacitor extending electrode 356 corresponding to the storage capacitor Cs.

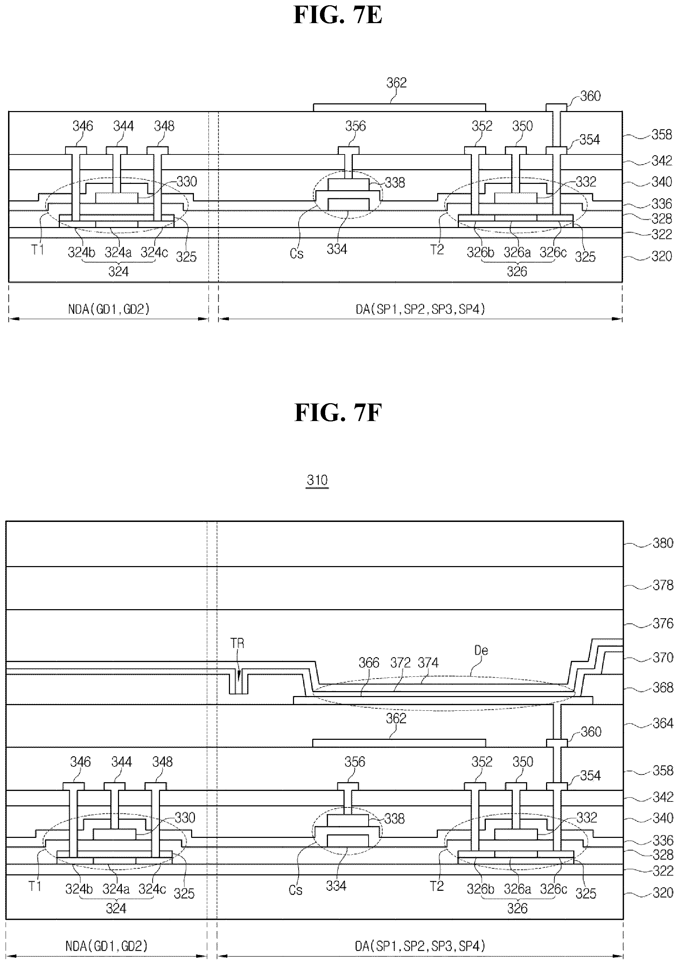

In FIG. 7E, after the first planarizing layer 358 is formed on the first gate extending electrode 344, the first source electrode 346, the first drain electrode 348, the second gate extending electrode 350, the second source electrode 352, the second drain electrode 354 and the capacitor extending electrode 356 over the entire substrate 320, the first planarizing layer 358 is patterned to form the contact hole exposing the second drain electrode 354 in the first planarizing layer 358.

Next, after a fourth metallic material layer (not shown) is formed on the first planarizing layer 358 over the entire substrate 320, the fourth metallic material layer is patterned to form the first connecting electrode 360 and the second connecting electrode 362 in each of the first to fourth subpixels SP1 to SP4 of the display area DA.

In FIG. 7F, after the second planarizing layer 364 is formed on the first connecting electrode 360 and the second connecting electrode 362 over the entire substrate 320, the second planarizing layer 364 is patterned to form the contact hole exposing the first connecting electrode 360 in the second planarizing layer 364.

Next, after a first electrode material layer (not shown) is formed on the second planarizing layer 364 over the entire substrate 320, the first electrode material layer is patterned to form the first electrode 366 in each of the first to fourth subpixels SP1 to SP4 of the display area DA.

Next, the bank layer 368 covering the edge portion of the first electrode 366 and having the opening exposing the central portion of the first electrode 366 is formed on the first electrode 366, and the spacer 370 is disposed on the bank layer 368. The trench TR is formed on the top surface of the bank layer 368 corresponding to the border portion between the adjacent two of the first to fourth subpixels SP1 to SP4.

Next, the emitting layer 372 is formed on the first electrode 366 over the entire substrate 320. The emitting layer 372 may be divided at the border portion between the adjacent two of the first to fourth subpixels SP1 to SP4 due to the trench TR.

Next, the second electrode 374 is disposed on the emitting layer 372 over the entire substrate 320. The second electrode 374 may not be divided due to the trench TR and may be connected and extend over the trench TR.

The first electrode 366, the emitting layer 372 and the second electrode 374 constitute the light emitting diode De.

Next, the first encapsulating layer 376, the second encapsulating layer 378 and the third encapsulating layer 380 are sequentially formed on the second electrode 374 over the entire substrate 320 to complete the display device 310.

Consequently, in the display device 310 according to a third embodiment of the present disclosure, since the first thin film transistor T1 using a polycrystalline semiconductor material as the semiconductor layer (active layer) and the second thin film transistor T2 using an oxide semiconductor material as the semiconductor layer (active layer) are disposed on the single substrate 320, the first thin film transistor T1 of the first and second gate driving units GD1 and GD2 has a relatively high mobility and the second thin film transistor T2 of each of the first to fourth subpixels SP1 to SP4 has a relatively low off current. As a result, a driving method such as a variable refresh rate (VRR) where a static image may be driven with a relatively low refresh rate and a moving image may be driven with a relatively high refresh rate is applied to the display device 310, and a power consumption is reduced.

Further, the first gate insulating layer 328 is formed commonly on the first semiconductor layer 324 of a polycrystalline semiconductor material and the second semiconductor layer 326 of an oxide semiconductor material, and the first gate electrode 330 and the second gate electrode 332 are formed as the same layer of the same material. As a result, a fabrication process is simplified and a fabrication cost is reduced.

In addition, the second gate insulating layer 325 is disposed on the first semiconductor layer 324, the second semiconductor layer 326 is disposed on the second gate insulating layer 325, and the first gate insulating layer 328 is disposed commonly on the first semiconductor layer 324 and the second semiconductor layer 326. As a result, a reliability of the first semiconductor layer 324 and the second semiconductor layer 326 is improved.

Moreover, since the first semiconductor layer 324, the second gate insulating layer 325 and the second semiconductor layer 326 are patterned using a single photo mask, a fabrication process is further simplified and a fabrication cost is further reduced.

In another embodiment, a fabrication process is simplified by forming a source electrode and a drain electrode as the same layer of same material.

FIG. 8 is a cross-sectional view showing a display area and a non-display area of a display device 410 according to a fourth embodiment of the present disclosure. Illustration on a part the same as that of the first to third embodiments may be omitted.

In FIG. 8, a first thin film transistor T1 as a circuit thin film transistor is disposed in first and second gate driving units GD1 and GD2 of a non-display area NDA of a display device 210 according to a fourth embodiment of the present disclosure, and a second thin film transistor T2 as a pixel thin film transistor, a storage capacitor Cs and a light emitting diode De are disposed in each of first to fourth subpixels SP1 to SP4 of a display area DA.

A first buffer layer 422 is disposed on an entire substrate 420. A first semiconductor layer 424 is disposed on the first buffer layer 422 in the first and second gate driving units GD1 and GD2 of the non-display area NDA.

For example, the first buffer layer 422 may have a single layer or a multiple layer of an inorganic insulating material such as silicon oxide (SiO2) and silicon nitride (SiNx).

The first semiconductor layer 424 includes a channel region 424a which is not doped with an impurity and source and drain regions 424b and 424c which are doped with an impurity at both sides of the channel region 424a.

For example, the first semiconductor layer 424 may include a polycrystalline semiconductor material such as polycrystalline silicon.

A second gate insulating layer 425 is disposed on the first semiconductor layer 424 and on the first buffer layer 422 in each of the first to fourth subpixels SP1 to SP4 of the display area DA, and a second semiconductor layer 426 is disposed on the second gate insulating layer 425 in each of the first to fourth subpixels SP1 to SP4 of the display area DA.

The first semiconductor layer 424 and the second gate insulating layer 425 on the first semiconductor layer 424 may have the same shape as each other in a plan view, and the second semiconductor layer 426 and the second gate insulating layer 425 under the second semiconductor layer 426 may have the same shape as each other in a plan view.

For example, the second gate insulating layer 425 may have a single layer or a multiple layer of an inorganic insulating material such as silicon oxide (SiO2) and silicon nitride (SiNx).

The second semiconductor layer 426 includes a channel region 426a which is not doped with an impurity and source and drain regions 426b and 426c which are doped with an impurity (conductorized) at both sides of the channel region 426a.

For example, the second semiconductor layer 426 may include an oxide semiconductor material such as indium gallium zinc oxide (IGZO), zinc oxide (ZnO), tin oxide (SnO2), copper oxide (Cu2O), nickel oxide (NiO), indium tin zinc oxide (ITZO) and indium aluminum zinc oxide (IAZO).

A first gate insulating layer 428 is disposed on the second gate insulating layer 425 and the second semiconductor layer 426 over the entire substrate 420. A first gate electrode 430 is disposed on the first gate insulating layer 428 corresponding to the first semiconductor layer 424, and a second gate electrode 432 is disposed on the first gate insulating layer 428 corresponding to the second semiconductor layer 426. A first capacitor electrode 434 is disposed on the first gate insulating layer 428 in each of the first to fourth subpixels SP1 to SP4 of the display area DA.

The second gate insulating layer 425 is disposed on the first semiconductor layer 424, the second semiconductor layer 426 is disposed on the second gate insulating layer 425, and the first gate insulating layer 428 is disposed commonly on the first semiconductor layer 424 and the second semiconductor layer 426. As a result, the second gate insulating layer 425 is formed under a condition suitable for the first semiconductor layer 424 of a polycrystalline semiconductor material (*e.g*., a condition based on a property change of the first semiconductor layer 424 according to an etching solution, a property change according to a deposition temperature of the first semiconductor layer 424 and the second gate insulating layer 425, a property change according to a surface treatment to the first semiconductor layer 424), and the first gate insulating layer 428 is formed under a condition suitable for the second semiconductor layer 426 of an oxide semiconductor material. Accordingly, a reliability of the first semiconductor layer 424 and the second semiconductor layer 426 is improved.

For example, a thickness of the second gate insulating layer 425 may be smaller than a thickness of the first gate insulating layer 428, and the first gate insulating layer 428 may have a single layer or a multiple layer of an inorganic insulating material such as silicon oxide (SiO2) and silicon nitride (SiNx).

The first gate electrode 430, the second gate electrode 432 and the first capacitor electrode 434 may have the same layer and the same material as each other.

For example, the first gate electrode 430, the second gate electrode 432 and the first capacitor electrode 434 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

The first gate electrode 430, the second gate insulating layer 425, the first gate insulating layer 428 and the first semiconductor layer 424 constitute the first thin film transistor T1, and the second gate electrode 432, the first gate insulating layer 428 and the second semiconductor layer 426 constitute the second thin film transistor T2.

A first interlayer insulating layer 436 is disposed on the first gate electrode 430, the second gate electrode 432 and the first capacitor electrode 434 over the entire substrate 420. A first gate extending electrode 444, a first source electrode 446 and a first drain electrode 448 are disposed on the first interlayer insulating layer 436 corresponding to the first thin film transistor T1, and a second gate extending electrode 450, a second source electrode 452 and a second drain electrode 454 are disposed on the first interlayer insulating layer 436 corresponding to the second thin film transistor T2. A second capacitor electrode 438 is disposed on the first interlayer insulating layer 436 corresponding to the first capacitor electrode 434.

For example, the first interlayer insulating layer 436 may have a single layer or a multiple layer of an inorganic insulating material such as silicon oxide (SiO2) and silicon nitride (SiNx).

The first gate extending electrode 444 is connected to the first gate electrode 430 through a contact hole in the first interlayer insulating layer 436. The first source electrode 446 is connected to the source region 424b of the first semiconductor layer 424 through a contact hole in the first interlayer insulating layer 436, the first gate insulating layer 428 and the second gate insulating layer 425, and the first drain electrode 448 is connected to the drain region 424c of the first semiconductor layer 424 through a contact hole in the first interlayer insulating layer 436, the first gate insulating layer 428 and the second gate insulating layer 425.

The second gate extending electrode 450 is connected to the second gate electrode 432 through a contact hole in the first interlayer insulating layer 436. The second source electrode 452 is connected to the source region 426b of the second semiconductor layer 426 through a contact hole in the first interlayer insulating layer 436 and the first gate insulating layer 428, and the second drain electrode 454 is connected to the drain region 426c of the second semiconductor layer 426 through a contact hole in the first interlayer insulating layer 436 and the first gate insulating layer 428.

The first capacitor electrode 434, the first interlayer insulating layer 436 and the second capacitor electrode 438 constitute the storage capacitor Cs.

For example, the first gate extending electrode 444, the first source electrode 446, the first drain electrode 448, the second gate extending electrode 450, the second source electrode 452, the second drain electrode 454 and the second capacitor electrode 438 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

A second buffer layer 440 is disposed on the first gate extending electrode 444, the first source electrode 446, the first drain electrode 448, the second gate extending electrode 450, the second source electrode 452, the second drain electrode 454 and the second capacitor electrode 438 over the entire substrate 420, and a first planarizing layer 458 is disposed on the second buffer layer 440 over the entire substrate 420.

For example, the second buffer layer 440 may have a single layer or a multiple layer of an inorganic insulating material such as silicon oxide (SiO2) and silicon nitride (SiNx), and the first planarizing layer 458 may have a single layer and a multiple layer of an inorganic insulating material such as photoacryl and benzocyclobutene (BCB).

A first source extending electrode 463 and a first drain extending electrode 461 are disposed on the first planarizing layer 458 corresponding to the first thin film transistor T1, and a second source extending electrode 462 and a second drain extending electrode 460 are disposed on the first planarizing layer 458 corresponding to the second thin film transistor T2. A second planarizing layer 464 is disposed on the first source extending electrode 463, the first drain extending electrode 461, the second source extending electrode 462 and the second drain extending electrode 460 over the entire substrate 420.

The first source extending electrode 463 is connected to the first source electrode 446 through a contact hole in the second buffer layer 440 and the first planarizing layer 458, and the first drain extending electrode 461 is connected to the first drain electrode 448 through a contact hole in the second buffer layer 440 and the first planarizing layer 458. The second source extending electrode 462 is connected to the second source electrode 452 and the second capacitor electrode 438 through a contact hole in the second buffer layer 440 and the first planarizing layer 458, and the second drain extending electrode 460 is connected to the second drain electrode 454 through a contact hole in the second buffer layer 440 and the first planarizing layer 458.

The first source extending electrode 463, the first drain extending electrode 461, the second source extending electrode 462 and the second drain extending electrode 460 may have the same layer and the same material as each other.

For example, the first source extending electrode 463, the first drain extending electrode 461, the second source extending electrode 462 and the second drain extending electrode 460 may have a single layer or a multiple layer of a metallic material such as one of molybdenum (Mo), aluminum (Al), chromium (Cr), gold (Au), titanium (Ti), nickel (Ni), neodymium (Nd), copper (Cu) and an alloy thereof.

For example, the second planarizing layer 464 may have a single layer and a multiple layer of an inorganic insulating material such as photoacryl and benzocyclobutene (BCB).

A first electrode 466 is disposed on the second planarizing layer 464 in each of the first to fourth subpixels SP1 to SP4 of the display area DA, and a bank layer 468 is disposed on the first electrode 466 over the entire substrate 420.

The first electrode 466 is connected to the first connecting electrode 460 through a contact hole in the second planarizing layer 464.

For example, the first electrode 466 may be an anode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The bank layer 468 covers an edge portion of the first electrode 466 and has an opening exposing a central portion of the first electrode 466.

For example, the bank layer 468 may have a single layer and a multiple layer of an inorganic insulating material such as photoacryl and benzocyclobutene (BCB).

A trench TR may be formed in a top surface of the bank layer 468 corresponding to a border portion between adjacent two of the first to fourth subpixels SP1 to SP4, and a spacer 470 may be disposed on the bank layer 468.

An emitting layer 472 is disposed on the first electrode 466 over the entire substrate 420, and a second electrode 474 is disposed on the emitting layer 472 over the entire substrate 420.

The emitting layer 472 contacts the first electrode 466 exposed through the opening of the bank layer 468, a sidewall of the opening of the bank layer 468, a top surface of the bank layer 468 and a sidewall and a top surface of the spacer 470. The emitting layer 472 may be divided at the border portion between the adjacent two of the first to fourth subpixels SP1 to SP4 due to the trench TR.

The emitting layer 472 may include a hole relating layer such as a hole injecting layer and a hole transporting layer and an electron relating layer such as an electron transporting layer and an electron injecting layer.

The second electrode 474 may not be divided due to the trench TR and may be connected and extend over the trench TR.

For example, the second electrode 474 may be a cathode and may have a single layer or a multiple layer of a transparent conductive material such as one of indium tin oxide (ITO), indium zinc oxide (IZO) and a half transmissive or opaque metallic material such as aluminum (Al), silver (Ag), copper (Cu), lead (Pb), magnesium (Mg), molybdenum (Mo), titanium (Ti) and an alloy thereof.

The first electrode 466, the emitting layer 472 and the second electrode 474 constitute the light emitting diode De.

A first encapsulating layer 476, a second encapsulating layer 478 and a third encapsulating layer 480 are sequentially disposed on the second electrode 474 over the entire substrate 420 for preventing a permeation of a moisture.

For example, the first encapsulating layer 476 and the third encapsulating layer 480 may have a single layer or a multiple layer of an inorganic insulating material such as silicon oxide (SiO2) and silicon nitride (SiNx), and the second encapsulating layer 478 may include an organic insulating material such as an acrylic resin, an epoxy resin, a phenolic resin, a polyamide resin and a polyimide resin.

A fabrication method of the display device 410 will be described with reference to drawings.

FIGs. 9A to 9E are cross-sectional views showing a method of fabricating a display device according to a fourth embodiment of the present disclosure.

In FIG. 9A, the first buffer layer 422 is disposed on the entire substrate 420.

Next, after an amorphous semiconductor material layer (not shown) is formed on the first buffer layer 422, the amorphous semiconductor material layer in the first and second gate driving units GD1 and GD2 of the non-display area NDA is selectively crystallized and the amorphous semiconductor material layer which is not crystallized is selectively removed to form a polycrystalline semiconductor pattern 423 in the first and second gate driving units GD1 and GD2 of the non-display area NDA.

Next, the second gate insulating layer 425 is formed on the polycrystalline semiconductor pattern 423 and the first buffer layer 422 over the entire substrate 420, and an oxide semiconductor material layer 427 is formed on the second gate insulating layer 425 over the entire substrate 420.

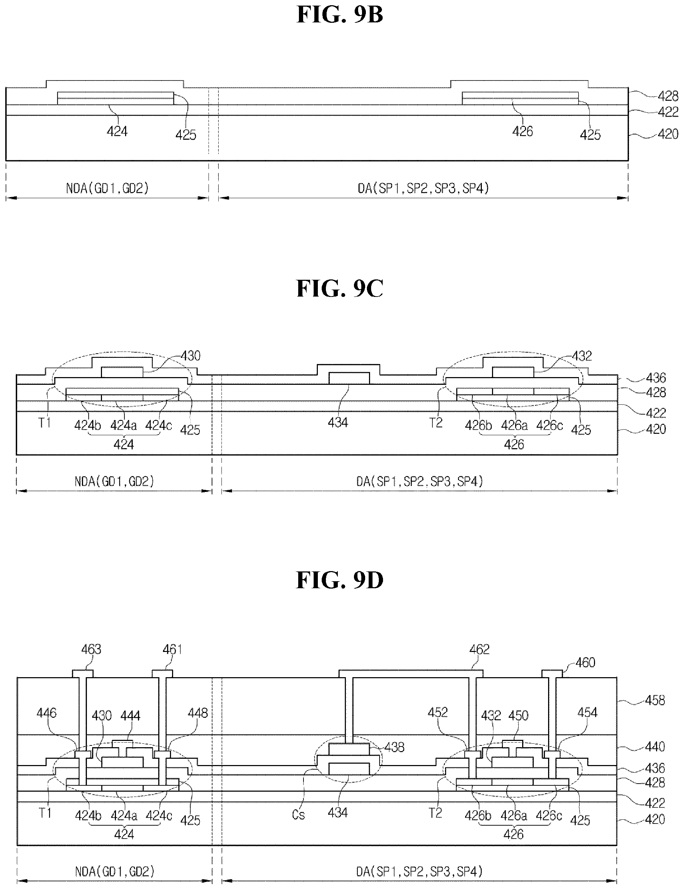

In FIG. 9B, after the oxide semiconductor material layer 427, the first gate insulating layer 425 and the polycrystalline semiconductor pattern 423 of the non-display area NDA and the oxide semiconductor material layer 427 and the first gate insulating layer 425 of the display area DA are etched using a half transmissive mask, a photoresist pattern is partially removed through an ashing to expose the oxide semiconductor material layer 427 of the non-display area NDA. Next, the exposed oxide semiconductor material layer 427 of the non-display area NDA is removed to form the first semiconductor layer 424 and the second gate insulating layer 425 on the first buffer layer 422 in the first and second gate driving units GD1 and GD2 of the non-display area NDA and to form the second gate insulating layer 425 and the second semiconductor layer 426 on the first buffer layer 422 in each of the first to fourth subpixels SP1 to SP4 of the display area DA.

Since the first semiconductor layer 424, the second gate insulating layer 425 and the second semiconductor layer 426 are patterned using a single photo mask, a fabrication process is simplified and a fabrication cost is reduced.

Next, the first gate insulating layer 428 is formed on the second gate insulating layer 425 and the second semiconductor layer 426 over the entire substrate 420.

In FIG. 9C, after a first metallic material layer (not shown) is formed on the first gate insulating layer 428, the first metallic material layer is patterned to form the first gate electrode 430 corresponding to the first semiconductor layer 424, the second gate electrode 432 corresponding to the second semiconductor layer 426 and the first capacitor electrode 434 in each of the first to fourth subpixels SP1 to SP4 of the display area DA.

Next, the first semiconductor layer 424 and the second semiconductor layer 426 are doped with an impurity of a negative type or a positive type using the first gate electrode 430 and the second gate electrode 432 as a doping mask to divide the first semiconductor layer 424 into the channel region 424a which is not doped with an impurity and the source and drain regions 424b and 424c which are doped with an impurity and to divide the second semiconductor layer 426 into the channel region 426a which is not doped with an impurity and the source and drain regions 426b and 426c which are doped with an impurity (or conductorized).

The first gate electrode 430, the first gate insulating layer 428, the second gate insulating layer 425 and the first semiconductor layer 424 constitute the first thin film transistor T1, and the second gate electrode 432, the first gate insulating layer 428 and the second semiconductor layer 426 constitute the second thin film transistor T2.

Next, the first interlayer insulating layer 436 is formed on the first gate electrode 430, the second gate electrode 432 and the first capacitor electrode 434 over the entire substrate 420.

In FIG. 9D, the first interlayer insulating layer 436 is patterned. As a result, the contact hole exposing the first gate electrode 430 is formed in the first interlayer insulating layer 436, the contact hole exposing the source region 424b of the first semiconductor layer 424 is formed in the first interlayer insulating layer 436, the first gate insulating layer 428 and the second gate insulating layer 425, and the contact hole exposing the drain region 424c of the first semiconductor layer 424 is formed in the first interlayer insulating layer 436, the first gate insulating layer 428 and the second gate insulating layer 425. The contact hole exposing the second gate electrode 432 is formed in the first interlayer insulating layer 436, the contact hole exposing the source region 426b of the second semiconductor layer 426 is formed in the first interlayer insulating layer 436, the first gate insulating layer 428 and the second gate insulating layer 425, and the contact hole exposing the drain region 426c of the second semiconductor layer 426 is formed in the first interlayer insulating layer 436, the first gate insulating layer 428 and the second gate insulating layer 425.

Next, after a second metallic material layer (not shown) is formed on the first interlayer insulating layer 436 over the entire substrate 420, the second metallic material layer is patterned to form the first gate extending electrode 444, the first source electrode 446 and the first drain electrode 448 corresponding to the first thin film transistor T1, the second gate extending electrode 450, the second source electrode 452 and the second drain electrode 454 corresponding to the second thin film transistor T2, and the second capacitor electrode 438 corresponding to the first capacitor electrode 434.

The first capacitor electrode 434, the first interlayer insulating layer 436 and the second capacitor electrode 438 constitute the storage capacitor Cs.

Next, after the second buffer layer 440 is formed on the first gate extending electrode 444, the first source electrode 446, the first drain electrode 448, the second gate extending electrode 450, the second source electrode 452, the second drain electrode 454 and the second capacitor electrode 438 over the entire substrate 420 and the first planarizing layer 458 is formed on the second buffer layer 440 over the entire substrate 420, the second buffer layer 440 and the first planarizing layer 458 are patterned. As a result, the contact hole exposing the first source electrode 446 is formed in the first planarizing layer 458 and the second buffer layer 440, and the contact hole exposing the first drain electrode 448 is formed in the first planarizing layer 458 and the second buffer layer 440. The contact hole exposing the second source electrode 452 is formed in the first planarizing layer 458 and the second buffer layer 440, and the contact hole exposing the second drain electrode 432 is formed in the first planarizing layer 458 and the second buffer layer 440. The contact hole exposing the second capacitor source electrode 438 is formed in the first planarizing layer 458 and the second buffer layer 440.

Next, after a third metallic material layer (not shown) is formed on the first planarizing layer 458 over the entire substrate 420, the third metallic material layer is patterned to form the first source extending electrode 463 and the first drain extending electrode 461 corresponding to the first thin film transistor T1, the second source extending electrode 462 corresponding to the second thin film transistor T2 and the storage capacitor Cs, and the second drain extending electrode 460 corresponding to the second thin film transistor T2.

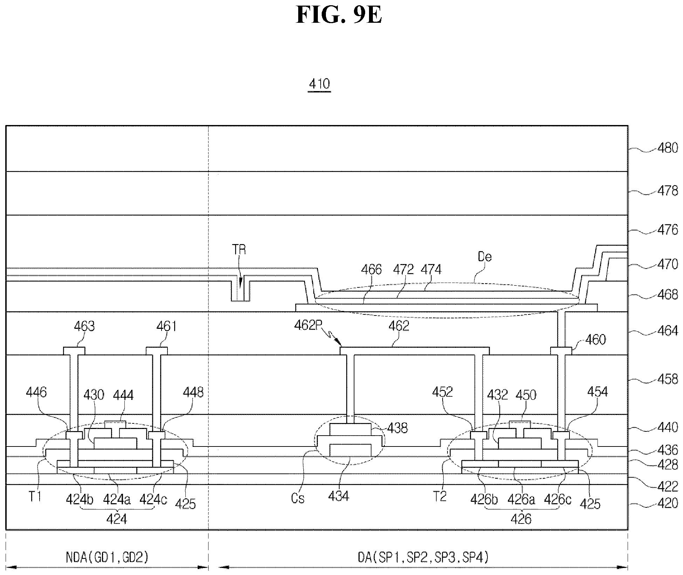

In FIG. 9E, after the second planarizing layer 464 is formed on the first source extending electrode 463, the first drain extending electrode 461, the second source extending electrode 462 and the second drain extending electrode 460 over the entire substrate 420, the second planarizing layer 464 is patterned to form the contact hole exposing the second drain extending electrode 460 in the second planarizing layer 464.

Next, after a first electrode material layer (not shown) is formed on the second planarizing layer 464 over the entire substrate 420, the first electrode material layer is patterned to form the first electrode 466 in each of the first to fourth subpixels SP1 to SP4 of the display area DA.

Next, the bank layer 468 covering the edge portion of the first electrode 466 and having the opening exposing the central portion of the first electrode 466 is formed on the first electrode 466, and the spacer 470 is disposed on the bank layer 468. The trench TR is formed on the top surface of the bank layer 468 corresponding to the border portion between the adjacent two of the first to fourth subpixels SP1 to SP4.

Next, the emitting layer 472 is formed on the first electrode 466 over the entire substrate 420. The emitting layer 472 may be divided at the border portion between the adjacent two of the first to fourth subpixels SP1 to SP4 due to the trench TR.

Next, the second electrode 474 is disposed on the emitting layer 472 over the entire substrate 420. The second electrode 474 may not be divided due to the trench TR and may be connected and extend over the trench TR.

The first electrode 466, the emitting layer 472 and the second electrode 474 constitute the light emitting diode De.

Next, the first encapsulating layer 476, the second encapsulating layer 478 and the third encapsulating layer 480 are sequentially formed on the second electrode 474 over the entire substrate 420 to complete the display device 410.

Consequently, in the display device 410 according to a fourth embodiment of the present disclosure, since the first thin film transistor T1 using a polycrystalline semiconductor material as the semiconductor layer (active layer) and the second thin film transistor T2 using an oxide semiconductor material as the semiconductor layer (active layer) are disposed on the single substrate 420, the first thin film transistor T1 of the first and second gate driving units GD1 and GD2 has a relatively high mobility and the second thin film transistor T2 of each of the first to fourth subpixels SP1 to SP4 has a relatively low off current. As a result, a driving method such as a variable refresh rate (VRR) where a static image may be driven with a relatively low refresh rate and a moving image may be driven with a relatively high refresh rate is applied to the display device 410, and a power consumption is reduced.

Further, the first gate insulating layer 428 is formed commonly on the first semiconductor layer 424 of a polycrystalline semiconductor material and the second semiconductor layer 426 of an oxide semiconductor material, and the first gate electrode 430 and the second gate electrode 432 are formed as the same layer of the same material. As a result, a fabrication process is simplified and a fabrication cost is reduced.

In addition, the second gate insulating layer 425 is disposed on the first semiconductor layer 424, the second semiconductor layer 426 is disposed on the second gate insulating layer 425, and the first gate insulating layer 428 is disposed commonly on the first semiconductor layer 424 and the second semiconductor layer 426. As a result, a reliability of the first semiconductor layer 424 and the second semiconductor layer 426 is improved.

Moreover, since the first semiconductor layer 424, the second gate insulating layer 425 and the second semiconductor layer 426 are patterned using a single photo mask, a fabrication process is further simplified and a fabrication cost is further reduced.

Furthermore, the first gate extending electrode 444, the first source electrode 446, the first drain electrode 448, the second gate extending electrode 450, the second source electrode 452 and the second drain electrode 454 are formed as the same layer of the same material, and the first source extending electrode 463, the first drain extending electrode 461, the second source extending electrode 462 and the second drain extending electrode 460 are formed as the same layer of the same material. As a result, a fabrication process is further simplified and a fabrication cost is further reduced.

In other words, the second source extending electrode 462 horizontally extends towards the capacitor Cs and overlaps the second capacitor electrode 438 from a plan view. Further, a portion of the second source extending electrode 462P that horizontally extended toward the capacitor Cs vertically extends towards the second capacitor electrode 438 to make an electrical connection.

It will be apparent to those skilled in the art that various modifications and variation can be made in the present disclosure without departing from the scope of the disclosure. Thus, it is intended that the present disclosure cover the modifications and variations of this disclosure, provided they come within the scope of the appended claims.

The various embodiments described above can be combined to provide further embodiments.

These and other changes can be made to the embodiments in light of the above-detailed description. In general, in the following claims, the terms used should not be construed to limit the claims to the specific embodiments disclosed in the specification and the claims. Accordingly, the claims are not limited by the disclosure.

## Claims

1. A display device (110, 210, 310, 410), comprising:
a substrate (120, 220, 320, 420) having a display area (DA) and a non-display area (NDA) adjacent to the display area (DA);
a first semiconductor layer (124, 224, 324, 424) and a second semiconductor layer (126, 226, 326, 426) on the substrate (120, 220, 320, 420), the first semiconductor layer (124, 224, 324, 424) disposed in the non-display area (NDA) and including a polycrystalline semiconductor material, and the second semiconductor layer (126, 226, 326, 426) disposed in the display area (DA) and including an oxide semiconductor material;
a first gate insulating layer (128, 228, 328, 428) on the first semiconductor layer (124, 224, 324, 424) and the second semiconductor layer (126, 226, 326, 426);
a first gate electrode (130, 230, 330, 430) and a second gate electrode (132, 232, 332, 432) on the first gate insulating layer (128, 228, 328, 428), the first gate electrode (130, 230, 330, 430) and the second gate electrode (132, 232, 332, 432) corresponding to the first semiconductor layer (124, 224, 324, 424) and the second semiconductor layer (126, 226, 326, 426), respectively;
a first interlayer insulating layer (136, 236, 336, 436) on the first gate electrode (130, 230, 330, 430) and the second gate electrode (132, 232, 332, 432); and
a first source electrode (146, 246, 346, 446), a first drain electrode (148, 248, 348, 448), a second source electrode (152, 252, 352, 452) and a second drain electrode (154, 254, 354, 454) on the first interlayer insulating layer (136, 236, 336, 436), the first source electrode (146, 246, 346, 446) and the first drain electrode (148, 248, 348, 448) coupled to both end portions, respectively, of the first semiconductor layer (124, 224, 324, 424), the second source electrode (152, 252, 352, 452) and the second drain electrode (154, 254, 354, 454) coupled to both end portions, respectively, of the second semiconductor layer (126, 226, 326, 426).

2. The display device (110) of claim 1, wherein the first semiconductor layer (124) and the second semiconductor layer (126) have a same layer as each other.

3. The display device (110, 210, 310) of claim 1 or 2, further comprising:
a first buffer layer (122, 222, 322) between the substrate (120, 220, 320) and the first semiconductor layer (124, 224, 324, 424) and between the substrate (120, 220, 320) and the second semiconductor layer (126, 226, 326);
a second buffer layer (140, 240, 340), a second interlayer insulating layer (142, 242, 342), a first planarizing layer (158, 258, 358) and a second planarizing layer (164, 264, 364) sequentially on the first interlayer insulating layer (136, 236, 336);
a storage capacitor (Cs) between the first gate insulating layer (128, 228, 328) and the second buffer layer (140, 240, 340);
a light emitting diode (De) on the second planarizing layer (164, 264, 364); and
a first encapsulating layer (176, 276, 376), a second encapsulating layer (178, 278, 378), and a third encapsulating layer (180, 280, 380) sequentially on the light emitting diode (De).

4. The display device (110, 210, 310) of claim 3, further comprising:
a first gate extending electrode (144, 244, 344) and a second gate extending electrode (150, 250, 350) coupled to the first gate electrode (130, 230, 330, 430) and the second gate electrode (132, 232, 332, 432), respectively; and
a capacitor extending electrode (156, 256, 356) coupled to the storage capacitor (Cs),
wherein the first gate extending electrode (144, 244, 344), the first source electrode (146, 246, 346, 446), the first drain electrode (148, 248, 348, 448), the second gate extending electrode (150, 250, 350), the second source electrode (152, 252, 352, 452) and the second drain electrode (154, 254, 354, 454) are disposed on the second interlayer insulating layer (142, 242, 342) and have a same layer and a same material as each other.

5. The display device (210, 310, 410) of any of claims 1 to 4, further comprising a second gate insulating layer (225, 325, 425) on the first semiconductor layer (124, 224, 324, 424),
wherein the second semiconductor layer (126, 226, 326, 426) is disposed on the second gate insulating layer (225, 325, 425).

6. The display device (210, 310, 410) of any of claims 1 to 4, further comprising a second gate insulating layer (225, 325, 425) on the first semiconductor layer (124, 224, 324, 424) and under the second semiconductor layer (126, 226, 326, 426), wherein the first semiconductor layer (324, 424) and the second gate insulating layer on the first semiconductor layer (324, 424) have a same shape as each other, and
wherein the second semiconductor layer (326, 426) and the second gate insulating layer (325, 425) under the second semiconductor layer (326, 426) have a same shape as each other.

7. The display device (410) of claim 1 or 2, further comprising a first gate extending electrode (444) and a second gate extending electrode (450) on the first interlayer insulating layer (436),
wherein the first gate extending electrode (444) and the second gate extending electrode (450) are coupled to the first gate electrode (430) and the second gate electrode (432), respectively, and
wherein the first gate extending electrode (444), the first source electrode (446), the first drain electrode (448), the second gate extending electrode (450), the second source electrode (452) and the second drain electrode (454) are disposed on the first interlayer insulating layer (436) and have a same layer and a same material as each other.

8. The display device (410) of claim 7, further comprising:
a first buffer layer (422) between the substrate (420) and the first semiconductor layer (424) and between the substrate (420) and the second semiconductor layer (426);
a second buffer layer (440), a first planarizing layer (458) and a second planarizing layer (464) sequentially on the first interlayer insulating layer (436);
a storage capacitor (Cs) between the first gate insulating layer (428) and the second buffer layer (440);
a light emitting diode (De) on the second planarizing layer (464); and
a first encapsulating layer (476), a second encapsulating layer (478) and a third encapsulating layer (480) sequentially on the light emitting diode (De).

9. The display device (410) of claim 8, further comprising a first source extending electrode (463), a first drain extending electrode (461), a second source extending electrode (462) and a second drain extending electrode (460) coupled to the first source electrode (446), the first drain electrode (448), the second source electrode (452) and the second drain electrode (454), respectively,
wherein the first source extending electrode (463), the first drain extending electrode (461), the second source extending electrode (462) and the second drain extending electrode (460) are disposed on the first planarizing layer (458) and have a same layer and a same material as each other.

10. The display device (410) of claim 9, wherein the second source electrode (452) is coupled to the storage capacitor (Cs).

11. The display device (210) of claim 1, further comprising:
a second gate insulating layer (225) adjacent to the first semiconductor layer (224) and the second semiconductor layer (226), the second gate insulating layer (225) extending from the first semiconductor layer (224) at the non-display area (NDA) to the second semiconductor layer (226) at the display area (DA);
wherein the first gate insulating layer (228) is on the second gate insulating layer (225),
wherein the display device (210) further comprises a light emitting diode (De) including a first electrode (266), a second electrode (274), and an emitting layer (272) between the first and second electrodes (266, 274), and
wherein the first electrode (266) of the light emitting diode (De) is coupled to either the second source electrode (252) or the second drain electrode (254) in the display area (DA).

12. The display device (210) of claim 11, further comprising:
a first buffer layer (222) between the substrate (220) and the first and second semiconductor layers (224, 226),
wherein the first buffer layer (222) continuously and contiguously extends from the first semiconductor layer (224) in the non-display area (NDA) to the second semiconductor layer (226) in the display area (DA),
wherein the first buffer layer (222) overlaps both the first semiconductor layer (224) in the non-display area (NDA) and the second semiconductor layer (226) in the display area (DA) from a plan view.

13. The display device of claim 12, wherein the first semiconductor layer (224) and the second semiconductor layer (226) directly contact the first buffer layer.

14. The display device (210) of any of claims 11 to 13, further comprising:
a capacitor (Cs) having a first capacitor electrode (234) and a second capacitor electrode (238) on the first capacitor electrode (234),
wherein the first capacitor electrode (234) is between the first gate electrode (230) in the non-display area (NDA) and the second gate electrode (232) in the display area (DA) from a plan view,
wherein, preferably, the first gate electrode (230), the second gate electrode (232), and the first capacitor electrode (234) are disposed on a same layer as each other and have a same material as each other.

15. The display device (210) of any of claims 11 to 14, wherein the second gate insulating layer (225) is disposed on and contacting the first semiconductor layer (224) at the non-display area (NDA), and
wherein the second semiconductor layer (226) is disposed on and contacting the second gate insulating layer (225) at the display area (DA).
